# EUROPEAN PATENT APPLICATION

(11) **EP 4 503 351 A1**
(43) Date of publication of application: **05.02.2025**
(21) Application number: 23774238.2
(22) Date of filing: 30.01.2023
(51) Int. Cl.: H01S 5/042, G01C 3/06, G01S 7/481, G01S 7/484, H01S 5/42, G01S 17/931

(54) **LIGHT EMITTING DEVICE AND DISTANCE MEASURING DEVICE**

(30) Priority: 25.03.2022 JP 2022050157
(71) Applicant: Sony Semiconductor Solutions Corporation, Atsugi-shi, Kanagawa 243-0014 (JP)
(72) Inventor: KAMIZURU, Hayato, Kikuchi-gun, Kumamoto 869-1102 (JP); KONISHI, Yoshio, Kikuchi-gun, Kumamoto 869-1102 (JP)
(74) Representative: Müller Hoffmann & Partner
(86) International application number: PCT/JP2023/002833
(87) International publication number: WO 2023/181639

(57) **Abstract**

There are provided a light-emitting device and a ranging device that optimize structures of wirings for light-emitting elements.

A light-emitting device according to the present disclosure includes: a plurality of light-emitting elements that are disposed in a two-dimensional array, and each include first and second terminals; a plurality of first terminal wirings that include first to Nth horizontal wirings (N represents an integer equal to or more than two) extending in a horizontal direction, and first to Nth vertical wirings extending in a vertical direction and electrically connected to the first to Nth horizontal wirings, respectively, and are electrically connected to the first terminals of the light-emitting elements; a plurality of second terminal wirings that are electrically connected to the second terminals of the light-emitting elements, and are each electrically connected to N light-emitting elements of the light-emitting elements; a plurality of selection circuits that are electrically connected to ones of the first and second terminal wirings, and select the light-emitting element that is caused to produce light; and a plurality of drive circuits that are electrically connected to other ones of the first and second terminal wirings, and drive the light-emitting elements.

## Description

### [Technical Field]

The present disclosure relates to a light-emitting device and a ranging device.

### [Background Art]

As a type of a semiconductor laser, surface emitting lasers such as Vertical Cavity Surface Emitting Lasers (VCSELs) are known. Generally, a light-emitting device that uses a surface emitting laser is provided with a plurality of light-emitting elements in a two-dimensional array on a top surface or a back surface of a substrate.

### [Citation List]

### [Patent Literature]

[PTL 1]
JP 2020-96169A

### [Summary]

### [Technical Problem]

When light-emitting elements of a VCSEL are caused to individually emit light, wirings for light-emitting elements become longer as the number of light-emitting elements becomes larger. As a result, there are problems that the impedance of each wiring becomes great, and a difference between impedances of wirings becomes great.

It is therefore an object of the present disclosure to provide a light-emitting device and a ranging device that optimize structures of wirings for light-emitting elements.

### [Solution to Problem]

A light-emitting device according to a first aspect of the present disclosure includes: a plurality of light-emitting elements that are disposed in a two-dimensional array, and each include first and second terminals; a plurality of first terminal wirings that include first to Nth horizontal wirings (N represents an integer equal to or more than two) extending in a horizontal direction, and first to Nth vertical wirings extending in a vertical direction and electrically connected to the first to Nth horizontal wirings, respectively, and are electrically connected to the first terminals of the light-emitting elements; a plurality of second terminal wirings that are electrically connected to the second terminals of the light-emitting elements, and are each electrically connected to N light-emitting elements of the light-emitting elements; a plurality of selection circuits that are electrically connected to ones of the first and second terminal wirings, and select the light-emitting element that is caused to produce light; and a plurality of drive circuits that are electrically connected to other ones of the first and second terminal wirings, and drive the light-emitting elements. Consequently, it is possible to reduce the impedance of each wiring and reduce a difference between the impedances of the wirings, that is, optimize structures of the wirings for the light-emitting elements.

Furthermore, according to this first aspect, one of the first and second terminals of the light-emitting element may be an anode, other one of the first and second terminals of the light-emitting element may be a cathode, one of the first and second terminal wirings may be an anode wiring, and other one of the first and second terminal wirings may be a cathode wiring. Consequently, it is possible to optimize, for example, structures of the anode wirings and the cathode wirings for the light-emitting elements.

Furthermore, according to this first aspect, the plurality of first terminal wirings may include M sets (M represents an integer equal to or more than two) of the first to Nth horizontal wirings and the first to Nth vertical wirings. Consequently, it is possible to dispose these horizontal wirings and vertical wirings in a mesh shape.

Furthermore, according to this first aspect, the plurality of selection circuits may include first to Nth selection circuits that are electrically connected to the first to Nth horizontal wirings or the first to Nth vertical wirings, respectively, and the plurality of drive circuits may be each electrically connected to one of the second terminal wirings. Consequently, it is possible to reduce, for example, the number of the selection circuits.

Furthermore, according to this first aspect, one of the first to Nth selection circuits and two or more of the plurality of drive circuits may be turned on to cause two or more of the light-emitting elements to simultaneously emit light. Consequently, it is possible to cause the two or more light-emitting elements to simultaneously emit light using the one selection circuit.

Furthermore, according to this first aspect, two or more of the first to Nth selection circuits and one of the plurality of drive circuits may be turned on to cause two or more of the light-emitting elements to simultaneously emit light. Consequently, it is possible to cause the two or more light-emitting elements to simultaneously emit light using the one drive circuit.

Furthermore, according to this first aspect, the plurality of selection circuits may be each electrically connected to one of the second terminal wirings, and the plurality of drive circuits may include first to third drive circuits that are electrically connected to the first to Nth horizontal wirings or the first to Nth vertical wirings, respectively. Consequently, it is possible to reduce, for example, the number of the drive circuits.

Furthermore, the light-emitting device according to this first aspect may further include a plurality of capacitors that are electrically connected to the ones of the first and second terminal wirings, and accumulate a charge to be supplied to the light-emitting elements. Consequently, it is possible to accumulate charges for the light-emitting elements using the capacitors.

Furthermore, according to this first aspect, the plurality of capacitors may include first to Nth capacitors that are electrically connected to the first to Nth horizontal wirings or the first to Nth vertical wirings, respectively. Consequently, it is possible to reduce, for example, the number of the capacitors.

Furthermore, according to this first aspect, the plurality of capacitors may include K sets (K represents an integer equal to or more than two) of the first to Nth capacitors that are disposed near two or more sides of four sides of an array of the light-emitting elements. Consequently, it is possible to set, for example, an average distance between each light-emitting element and these capacitors to a value close to an average distance between another light-emitting element and these capacitors.

Furthermore, according to this first aspect, the plurality of capacitors may include K sets (K represents an integer equal to or more than two) of the first to Nth capacitors that are disposed symmetrically with respect to a center of an array of the light-emitting elements. Consequently, it is possible to set, for example, an average distance between each light-emitting element and these capacitors to a value close to an average distance between another light-emitting element and these capacitors.

Furthermore, according to this first aspect, the plurality of capacitors may be each electrically connected to one of the second terminal wirings. Consequently, it is possible to reduce, for example, the number of the drive circuits.

Furthermore, according to this first aspect, the plurality of capacitors may be disposed on a first substrate provided with the light-emitting elements, a second substrate provided with at least ones of the selection circuits and the drive circuits, or a mounting substrate provided with the first and second substrates. Consequently, it is possible to dispose the capacitors at various portions according to, for example, a design of the light-emitting device.

Furthermore, according to this first aspect, each of the plurality of selection circuits may include a first switch that accumulates a charge in the capacitors, and a second switch that discharges the charge from the capacitors. Consequently, it is possible to control, for example, accumulation and discharging of the capacitors using the selection circuits.

Furthermore, the light-emitting device according to this first aspect may further include a plurality of voltage detection circuits that detect a voltage indicating an amount of a charge accumulated in the plurality of capacitors, and control the first switch on a basis of the voltage. Consequently, it is possible to suitably control, for example, the charge amount of the capacitors.

Furthermore, according to this first aspect, a charge to be supplied to the light-emitting elements may be accumulated in parasitic capacitances of the light-emitting elements or the drive circuits. Consequently, it is possible to accumulate charges for the light-emitting elements without using the capacitors.

Furthermore, according to this first aspect, each of the plurality of drive circuits may include a first transistor that selects the light-emitting element that is caused to produce the light, and a second transistor that functions as a current source. Consequently, it is possible to optimize, for example, the structures of the drive circuits (output stages) that select and cause the light-emitting elements to produce (output) light.

Furthermore, according to this first aspect, the first substrate provided with the light-emitting elements may be stacked on the second substrate provided with at least ones of the selection circuits and the drive circuits. Consequently, for example, it is possible to dispose these substrates in a narrow region, and dispose these substrates close to each other.

Furthermore, according to this first aspect, a size of one of the plurality of drive circuits may be same as a size of N light-emitting elements of the plurality of light-emitting elements in plan view. Consequently, it is possible to dispose, for example, the N light-emitting elements on each drive circuit.

A ranging device according to a second aspect of the present disclosure includes: a light-emitting unit that produces light and emits the light to a subject; a light receiving unit that receives the light reflected from the subject; and a ranging unit that measures a distance to the subject on a basis of the light received by the light receiving unit, and the light-emitting unit includes: a plurality of light-emitting elements that are disposed in a two-dimensional array, and each include first and second terminals; a plurality of first terminal wirings that include first to Nth horizontal wirings (N represents an integer equal to or more than two) extending in a horizontal direction, and a first to Nth vertical wirings extending in a vertical direction and electrically connected to the first to Nth horizontal wirings, respectively, and are electrically connected to the first terminals of the light-emitting elements; a plurality of second terminal wirings that are electrically connected to the second terminals of the light-emitting elements, and are each electrically connected to N light-emitting elements of the light-emitting elements; a plurality of selection circuits that are electrically connected to ones of the first and second terminal wirings, and select the light-emitting element that is caused to produce light; and a plurality of drive circuits that are electrically connected to other ones of the first and second terminal wirings, and drive the light-emitting elements. Consequently, it is possible to reduce the impedance of each wiring and reduce a difference between the impedances of the wirings, that is, optimize structures of the wirings for the light-emitting elements.

### [Brief Description of Drawings]

[Fig. 1]

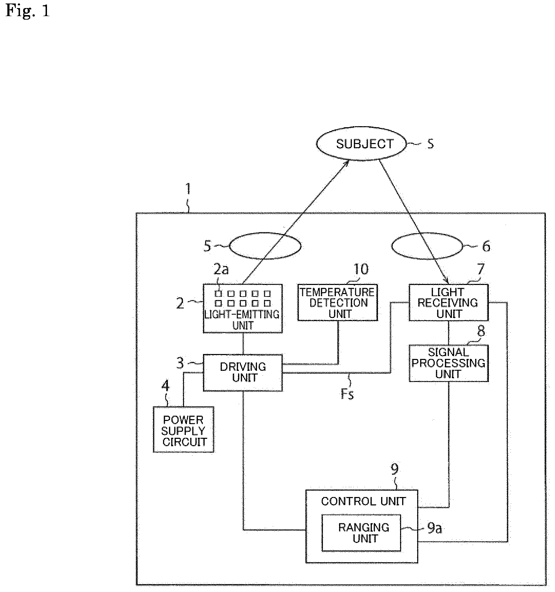

   Fig. 1 is a block diagram illustrating a configuration example of a ranging device 1 according to a first embodiment.
[Fig. 2]

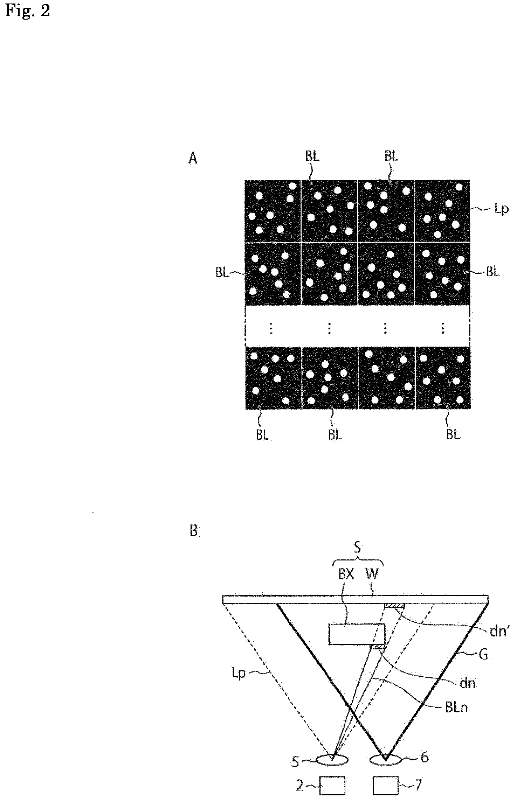

   Fig. 2 is a diagram for describing a Structured Light (STL) scheme according to the first embodiment.
[Fig. 3]

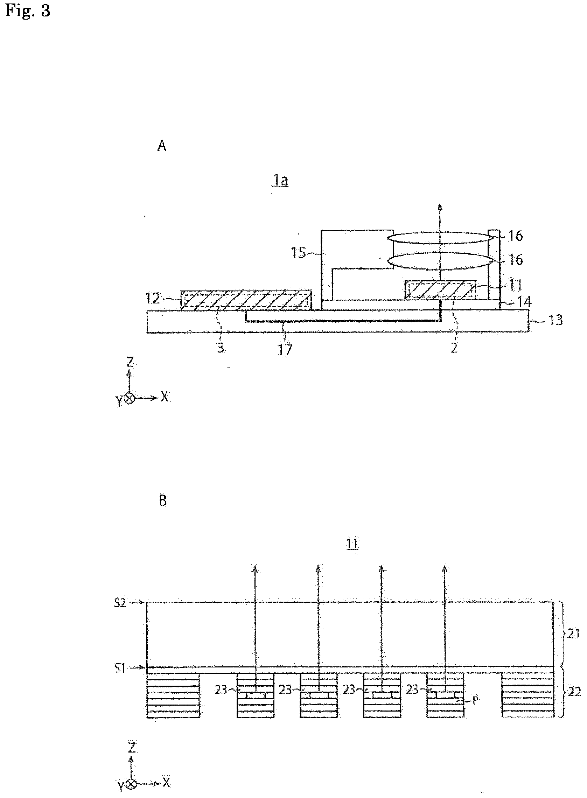

   Fig. 3 is a cross-sectional view illustrating a structure of a light-emitting device 1a according to the first embodiment.
[Fig. 4]

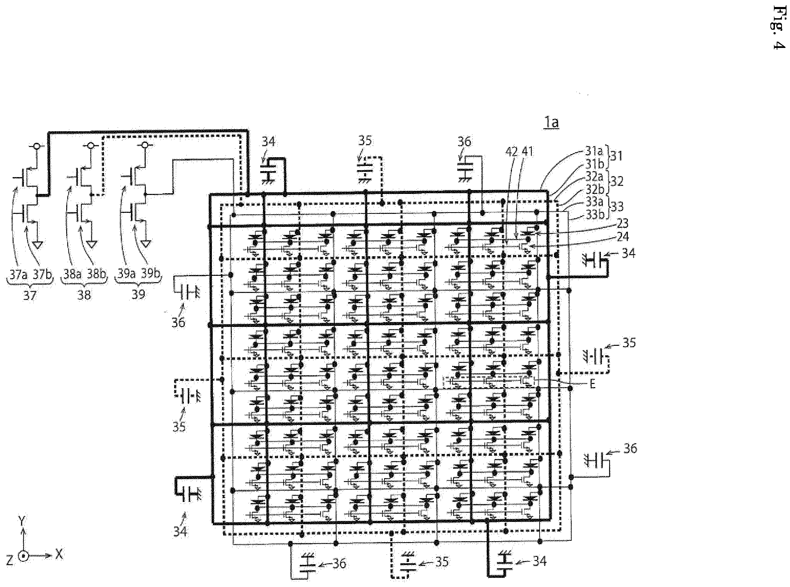

   Fig. 4 is a circuit diagram illustrating the structure of the light-emitting device 1a according to the first embodiment.
[Fig. 5]

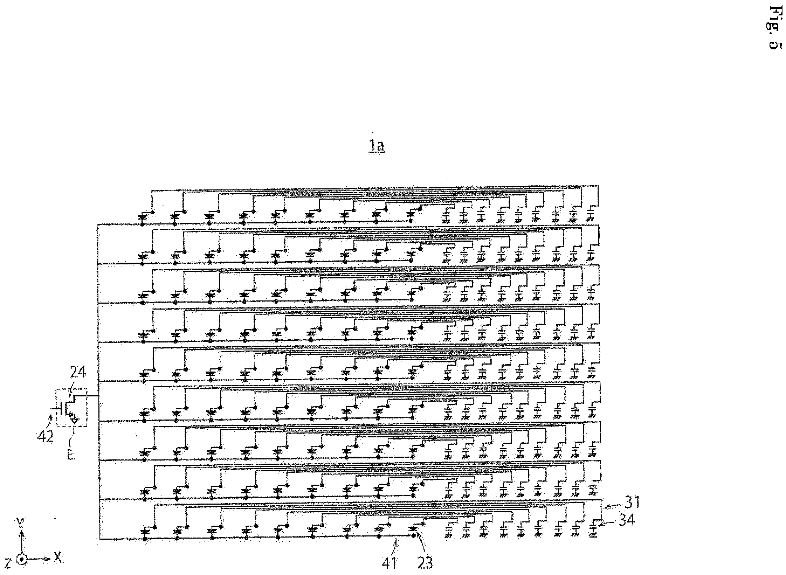

   Fig. 5 is a circuit diagram illustrating the structure of the light-emitting device 1a according to a comparative example of the first embodiment.
[Fig. 6]

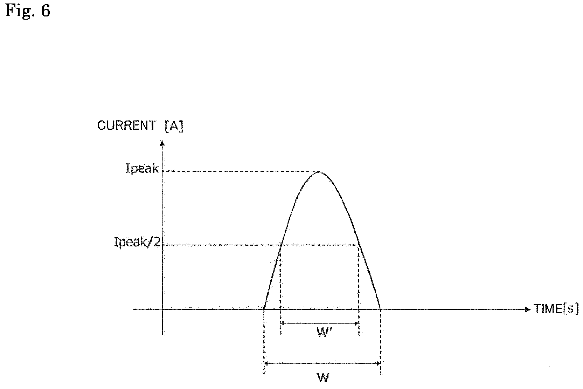

   Fig. 6 shows a graph for describing performance of the light-emitting device 1a according to the first embodiment.
[Fig. 7]

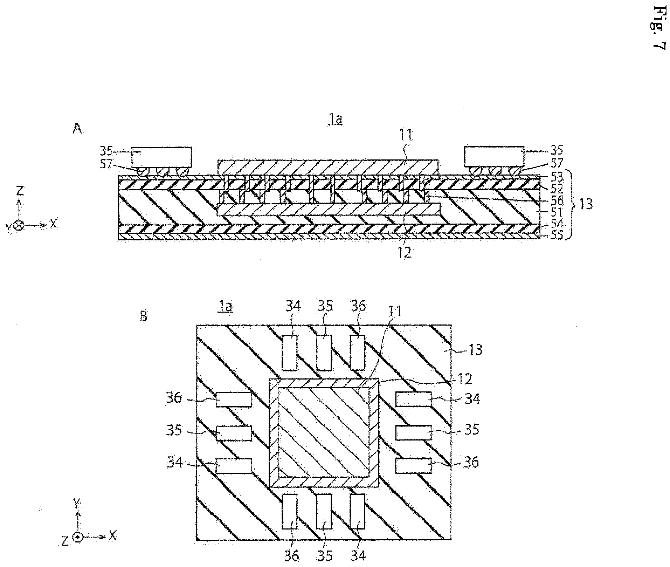

   Fig. 7 is a cross-sectional view and a plan view illustrating the structure of the light-emitting device 1a according to the first embodiment.
[Fig. 8]

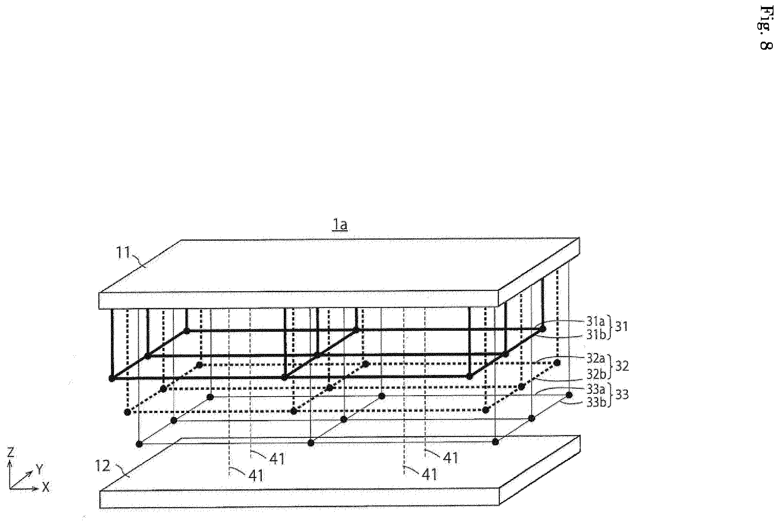

   Fig. 8 is a perspective view schematically illustrating the structure of the light-emitting device 1a according to the first embodiment.
[Fig. 9]

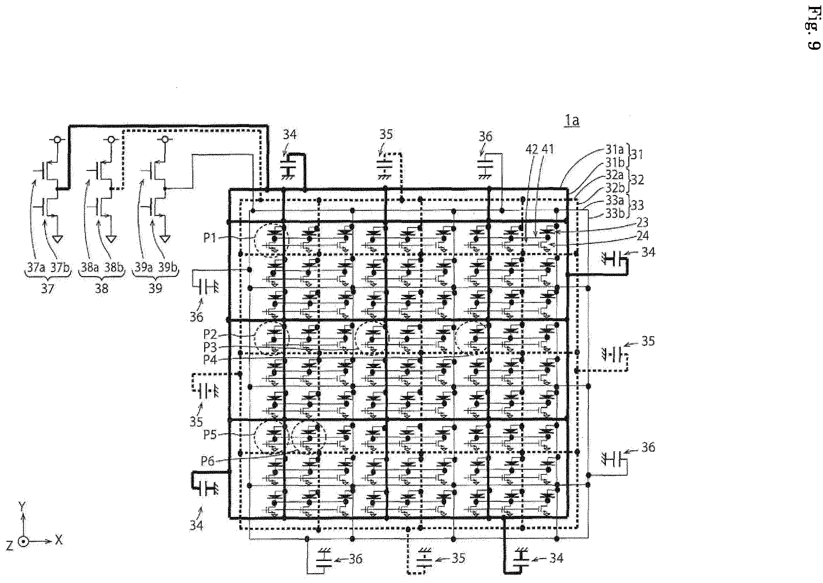

   Fig. 9 is a circuit diagram illustrating the structure of the light-emitting device 1a according to a first modification example of the first embodiment.
[Fig. 10]

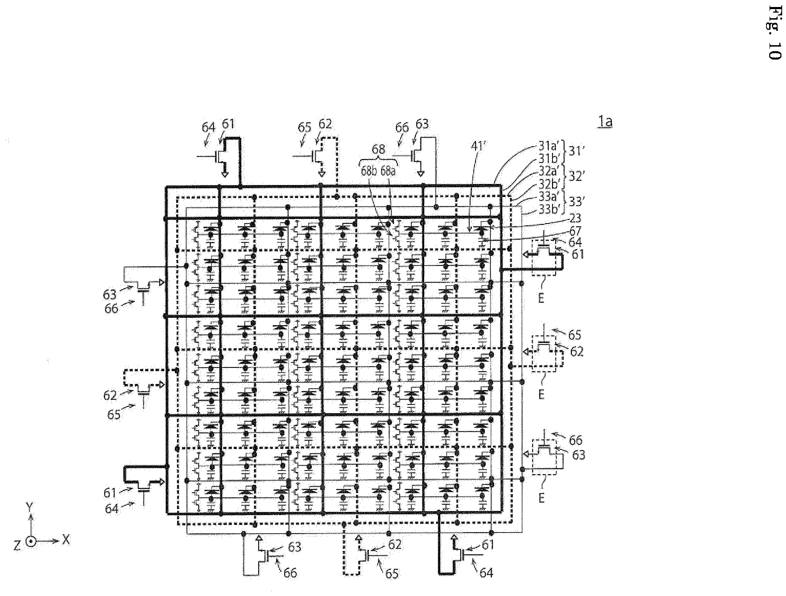

   Fig. 10 is a circuit diagram illustrating the structure of the light-emitting device 1a according to a second modification example of the first embodiment.
[Fig. 11]

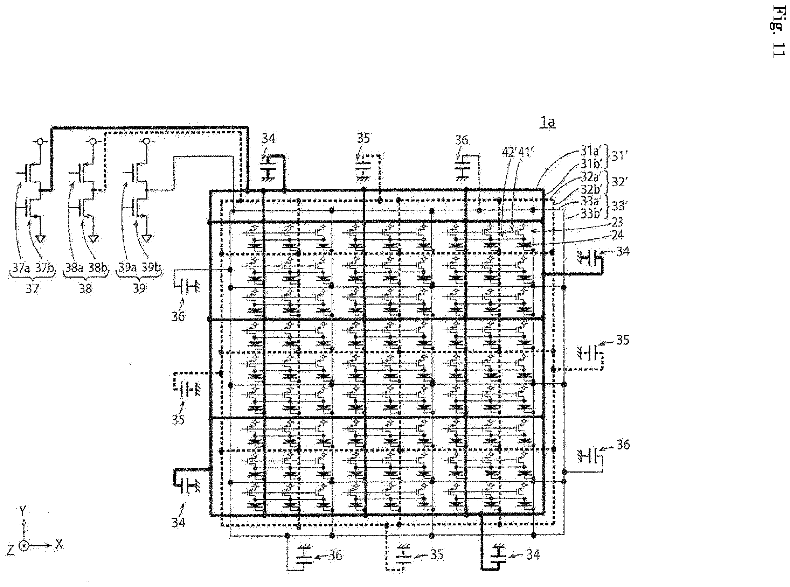

   Fig. 11 is a circuit diagram illustrating the structure of the light-emitting device 1a according to a third modification example of the first embodiment.
[Fig. 12]

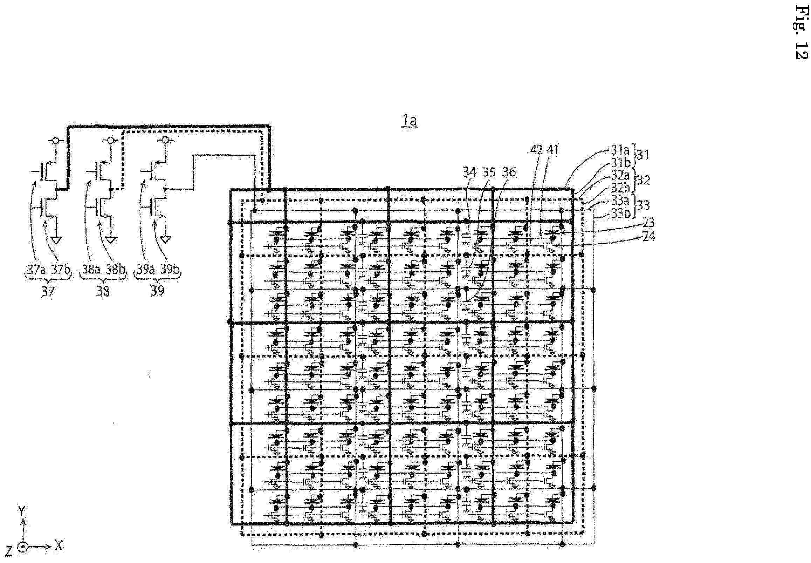

   Fig. 12 is a circuit diagram illustrating the structure of the light-emitting device 1a according to a fourth modification example of the first embodiment.
[Fig. 13]

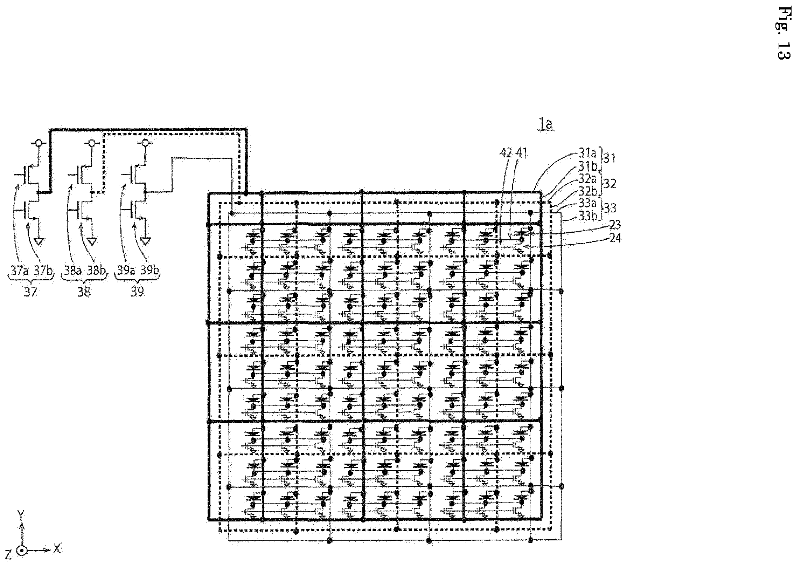

   Fig. 13 is a circuit diagram illustrating the structure of the light-emitting device 1a according to a fifth modification example of the first embodiment.
[Fig. 14]

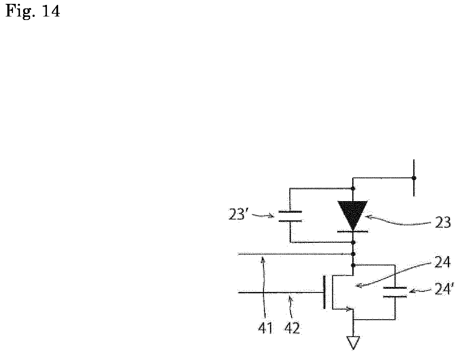

   Fig. 14 is another circuit diagram illustrating the structure of the light-emitting device 1a according to a fifth modification example of the first embodiment.
[Fig. 15]

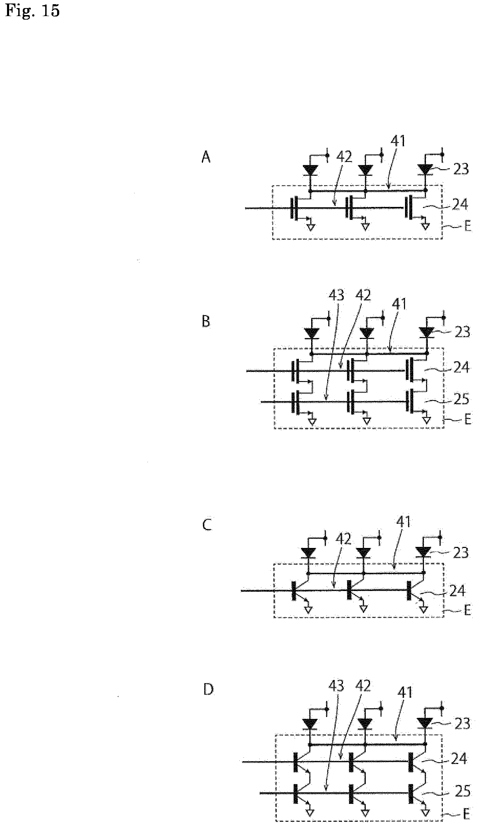

   Fig. 15 is a circuit diagram illustrating various examples of the structure of the light-emitting device 1a according to a sixth modification example of the first embodiment.
[Fig. 16]

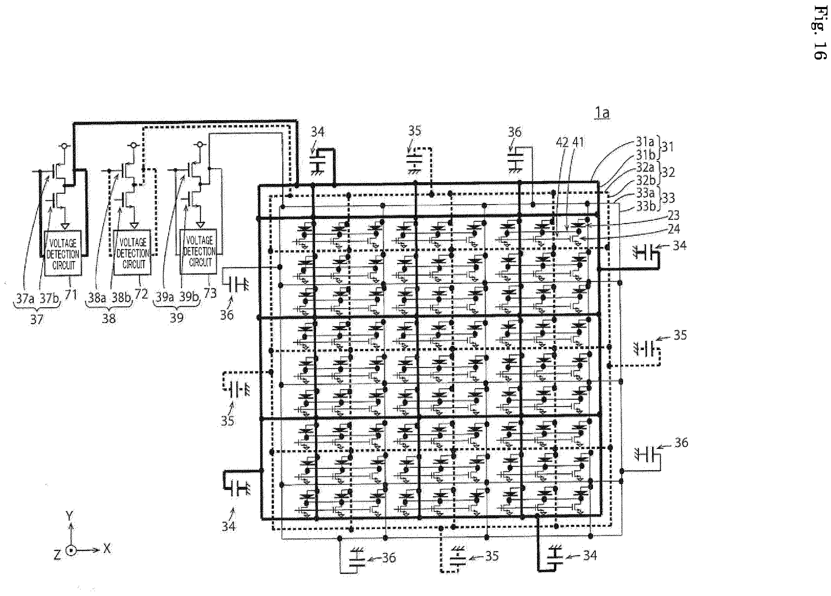

   Fig. 16 is a circuit diagram illustrating the structure of the light-emitting device 1a according to a seventh modification example of the first embodiment.
[Fig. 17]

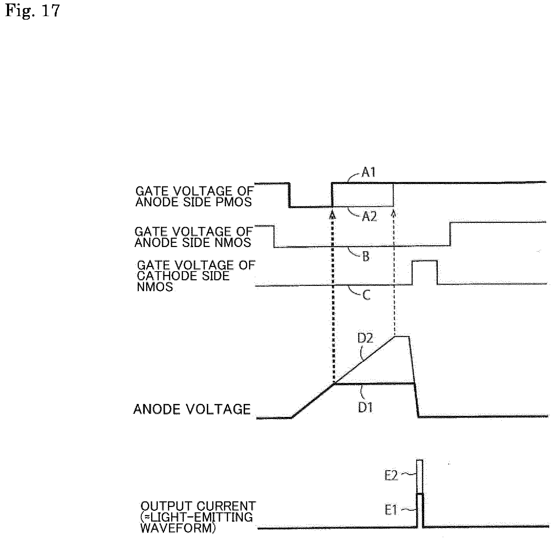

   Fig. 17 is a timing chart illustrating an operation of the light-emitting device 1a according to the seventh modification example of the first embodiment.
[Fig. 18]

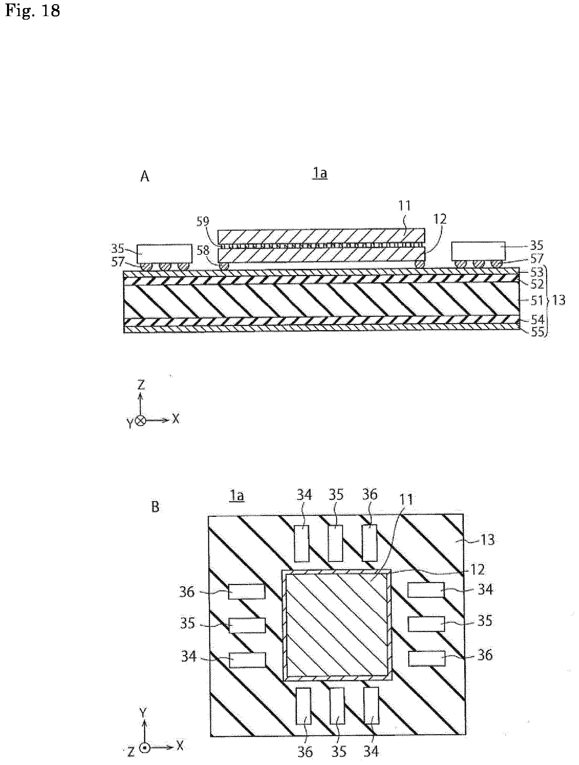

   Fig. 18 is a cross-sectional view and a plan view illustrating the structure of the light-emitting device 1a according to an eighth modification example of the first embodiment.
[Fig. 19]

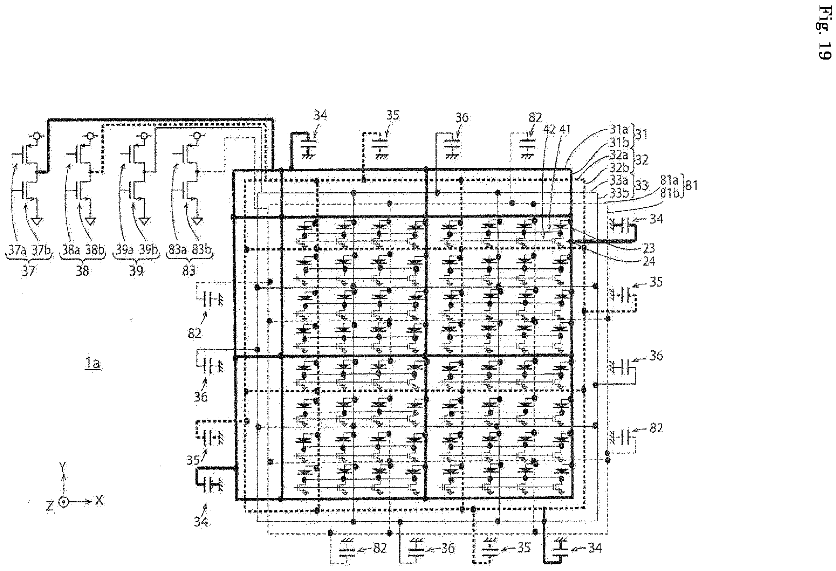

   Fig. 19 is a circuit diagram illustrating the structure of the light-emitting device 1a according to the second embodiment.
[Fig. 20]

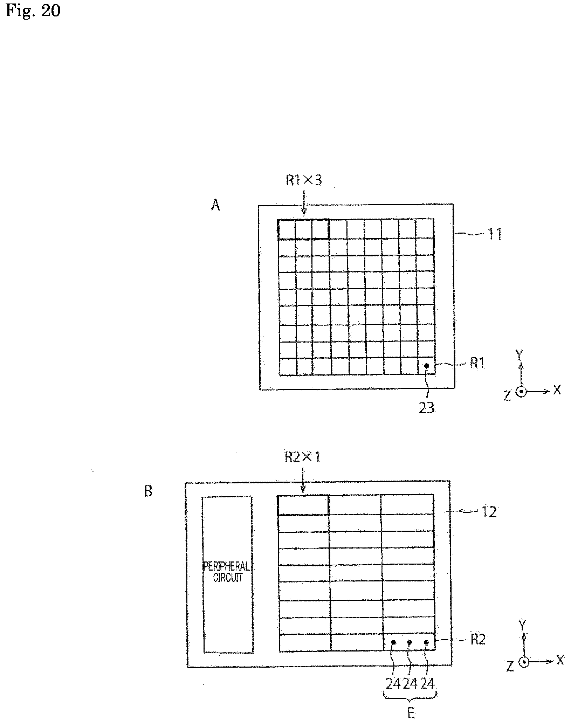

   Fig. 20 is a plan view schematically illustrating the structure of the light-emitting device 1a according to a third embodiment.

### [Description of Embodiments]

Hereinafter, embodiments of the present disclosure will be described with reference to the drawings.

### (First Embodiment)

### (1) Ranging Device 1 According to First Embodiment

### (1.1) Configuration of Ranging Device 1

Fig. 1 is a block diagram illustrating a configuration example of the ranging device 1 according to the first embodiment. The ranging device 1 according to the present embodiment is mounted on, for example, a car.

As illustrated in Fig. 1, the ranging device 1 includes a light-emitting unit 2, a driving unit 3, a power supply circuit 4, a light-emitting side optical system 5, a light receiving side optical system 6, a light receiving unit 7, a signal processing unit 8, a control unit 9, and a temperature detection unit 10.

The light-emitting unit 2 emits light using a plurality of light sources. The light-emitting unit 2 according to the present embodiment includes a plurality of light-emitting elements 2a using a Vertical Cavity Surface Emitting Laser (VCSEL) as light sources, and is configured such that the light-emitting elements 2a are arranged in a predetermined form, e.g., a matrix.

The driving unit 3 includes a power supply circuit for driving the light-emitting unit 2.

The power supply circuit 4 generates a power supply voltage of the driving unit 3 on the basis of, for example, an input voltage from a battery or the like, which is not illustrated, in the ranging device 1. The driving unit 3 drives the light-emitting unit 2 on the basis of the power supply voltage.

Light emitted from the light-emitting unit 2 is radiated on a subject S, which is a target of ranging, through the light-emitting side optical system 5. Furthermore, light that is light radiated in this way and reflected from the subject S enters the light receiving surface of the light receiving unit 7 through the light receiving side optical system 6.

The light receiving unit 7 is, for example, a light receiving element such as a Charge Coupled Device (CCD) sensor or a Complementary Metal-Oxide Semiconductor (CMOS) sensor, and receives the light that enters through the light receiving side optical system 6 as described above and is reflected from the subject S, converts the light into an electrical signal, and outputs the electrical signal.

The light receiving unit 7 executes, for example, Correlated Double Sampling (CDS) processing, Automatic Gain Control (AGC) processing, and the like on the electrical signal obtained by photoelectrically converting the received light, and further performs Analog/Digital (A/D) conversion processing thereon. Furthermore, a signal as digital data is output to the signal processing unit 8 at a subsequent stage.

Moreover, the light receiving unit 7 according to the present embodiment outputs a frame synchronizing signal Fs to the driving unit 3. Thus, the driving unit 3 can cause the light-emitting elements 2a in the light-emitting unit 2 to emit light at a timing corresponding to a frame period of the light receiving unit 7.

The signal processing unit 8 is configured as a signal processor by, for example, a Digital Signal Processor (DSP). The signal processing unit 8 performs various kinds of signal processing on a digital signal input from the light receiving unit 7.

The control unit 9 is configured as a microcomputer including, for example, a Central Processing Unit (CPU), a Read Only Memory (ROM), and a Random Access Memory (RAM) or is configured as an information processing device such as a DSP, and controls the driving unit 3 to control a light-emitting operation of the light-emitting unit 2 and controls a light receiving operation of the light receiving unit 7.

The control unit 9 has a function as a ranging unit 9a. The ranging unit 9a measures a distance to the subject S on the basis of a signal (that is, a signal obtained by receiving the light reflected from the subject S) input through the signal processing unit 8. The ranging unit 9a according to the present embodiment measures a distance to each part of the subject S to specify the three-dimensional shape of the subject S.

Here, a more specific ranging method of the ranging device 1 will be described later again.

The temperature detection unit 10 detects the temperature of the light-emitting unit 2. The temperature detection unit 10 can be configured to detect a temperature by using, for example, a diode.

In the present embodiment, information about the temperature detected by the temperature detection unit 10 is supplied to the driving unit 3, so that the driving unit 3 can drive the light-emitting unit 2 on the basis of information about the temperature.

### (1.2) Regarding Ranging Method

The ranging method of the ranging device 1 adopts, for example, a ranging method of a Structured Light (STL) scheme or a Time of Flight (ToF) scheme.

The STL scheme is a scheme of measuring a distance on the basis of an image of the subject S irradiated with light having a predetermined bright/dark pattern such as a dot pattern or a lattice pattern.

Fig. 2 is a diagram for describing the STL scheme according to the first embodiment.

According to the STL scheme, pattern light Lp of a dot pattern as illustrated in, for example, A of Fig. 2 is radiated on the subject S. The pattern light Lp is split into a plurality of blocks BL, and each block BL is assigned a different dot pattern (dot patterns do not overlap between the blocks B).

B of Fig. 2 is an explanatory drawing of a ranging principle of the STL scheme.

Here, an example is illustrated where a wall W and a box BX disposed in front of the wall W are the subjects S, and the pattern light Lp is radiated on the subjects S. "G" in B of Fig. 2 schematically represents an angle of view of the light receiving unit 7.

Furthermore, "BLn" in B of Fig. 2 means light of the certain block BL of the pattern light Lp. "dn" means a dot pattern of the block BLn shown in a light receiving image obtained by the light receiving unit 7.

Here, when there is not the box BX in front of the wall W, a dot pattern of the block BLn in a light receiving image is shown at a position of "dn‴ in B of Fig. 2. That is, positions at which patterns of the block BLn are shown in the light receiving image are different between a case where there is the box BX and a case where there is not the box BX, and, more specifically, the pattern is distorted.

The STL scheme is a scheme of finding the shape or the depth of the subject S using a fact that a radiated pattern is distorted depending on an object shape of the subject S as described above. More specifically, the STL scheme is a scheme of finding the shape or the depth of the subject S from how the pattern is distorted.

In a case where the STL scheme is adopted, for example, an Infrared (IR) light receiving unit of a global shutter scheme is used as the light receiving unit 7. Furthermore, in the case of the STL scheme, the ranging unit 9a controls the driving unit 3 such that the light-emitting unit 2 emits pattern light, and detects distortion of a pattern of an image signal obtained via the signal processing unit 8 and calculates a distance on the basis of how the pattern is distorted.

Next, the ToF scheme is a scheme of measuring a distance to a target by detecting a time of flight (time difference) of light taken to reach the light receiving unit 7 after the light emitted from the light-emitting unit 2 is reflected by the target.

In a case where a so-called direct ToF (dToF) scheme is adopted as the ToF method, a Single Photon Avalanche Diode (SPAD) is used as the light receiving unit 7, and the light-emitting unit 2 performs pulse driving. In this case, the ranging unit 9a calculates a time difference from emission to reception of light that is emitted from the light-emitting unit 2 and is received by the light receiving unit 7, on the basis of a signal input through the signal processing unit 8, and calculates a distance to each part of the subject S on the basis of the time difference and the speed of light. According to the dToF scheme, the distance to the subject S is calculated by calculating the time from light emission to light reception, so that it is possible to improve resolution of the time when a light-emitting pulse width narrows, and perform more precise ranging. Hence, the dToF scheme is more suitable to the present embodiment that achieves higher power and a shorter pulse of light emission.

Note that, in a case where a so-called indirect ToF (iToF) scheme (phase difference method) is adopted as the ToF method, for example, a light receiving unit that can receive IR is used as the light receiving unit 7. According to the iToF scheme, since a distance to a subject is calculated from a phase difference between emitted light and light reflected and received from the subject is calculated, the waveform of an LDD output current at a time of light emission desirably steeply rises and falls. Since the inductances of wirings in the light-emitting elements 2a are reduced to improve the characteristics of the above waveform, the present embodiment is also suitable to the iToF scheme.

### (2) Light-Emitting Device 1a According to First Embodiment

Fig. 3 is a cross-sectional view illustrating a structure of the light-emitting device 1a according to the first embodiment. A of Fig. 3 illustrates the cross section of the light-emitting device 1a according to the present embodiment, and B of Fig. 3 illustrates the cross section enlarged from the cross section illustrated in A of Fig. 3. The light-emitting device 1a according to the present embodiment may be part of the ranging device 1, or may be the ranging device 1 itself.

The light-emitting device 1a in A of Fig. 3 includes a Laser Diode (LD) chip 11 that includes the above-described light-emitting unit 2, a Laser Diode Driver (LDD) substrate 12 that includes the above-described driving unit 3, a mounting substrate 13, a heat dissipation substrate 14, a correction lens holding part 15, one or more correction lenses 16, and a wiring 17. The LD chip 11 is also referred to as a VCSEL substrate. The LD chip 11 is an example of a first substrate according to the present disclosure, and the LDD substrate 12 is an example of a second substrate according to the present disclosure.

A of Fig. 3 illustrates the X axis, the Y axis, and the Z axis that are perpendicular to each other. The +Z direction corresponds to the upward direction, and the -Z direction corresponds to the downward direction. Note that the -Z direction may exactly match the gravity direction, or may not exactly match the gravity direction.

The LD chip 11 is disposed above the mounting substrate 13 with the heat dissipation substrate 14 interposed therebetween, and the LDD substrate 12 is also disposed on the mounting substrate 13. The mounting substrate 13 is, for example, a printed circuit board. The above-described light receiving unit 7 and signal processing unit 8 may be further disposed on the mounting substrate 13. The heat dissipation substrate 14 is a ceramic substrate such as an aluminum oxide substrate or an aluminum nitride substrate.

The correction lens holding part 15 is disposed above the heat dissipation substrate 14 to surround the LD chip 11, and holds the one or more correction lenses 16 above the LD chip 11. These correction lenses 16 are included in the above-described light-emitting side optical system 5. Light emitted from the light-emitting unit 2 in the LD chip 11 is corrected by these correction lenses 16, and then is radiated on the above-described subject S. A of Fig. 3 illustrates, for example, the two correction lenses 16 held by the correction lens holding part 15.

The wiring 17 is provided on the top surface or the back surface of or inside the mounting substrate 13 to electrically connect the LD chip 11 and the LDD substrate 12. The wiring 17 is, for example, a printed wiring provided on the top surface or the back surface of the mounting substrate 13, or a via wiring that penetrates the mounting substrate 13. The wiring 17 according to the present embodiment passes inside or near the heat dissipation substrate 14.

The LD chip 11 in B of Fig. 3 includes a substrate 21, a laminated film 22, and a plurality of light-emitting elements 23. These light-emitting elements 23 are specific examples of the above-described light-emitting elements 2a.

The substrate 21 is, for example, a compound semiconductor substrate such as a GaAs (gallium arsenide) substrate. B of Fig. 3 illustrates a top surface S1 of the substrate 21 that faces the -Z direction, and a back surface S2 of the substrate 21 that faces the +Z direction. The top surface S1 and the back surface S2 illustrated in B of Fig. 3 are perpendicular to the Z direction. In B of Fig. 3, the top surface S1 is the lower surface of the substrate 21, and the back surface S2 is the upper surface of the substrate 21.

The laminated film 22 includes a plurality of layers laminated on the top surface S1 of the substrate 21. Examples of these layers include an n-type semiconductor layer, an active layer, a p-type semiconductor layer, a light reflection layer, and an insulation layer that includes a light emission window. The laminated film 22 includes a plurality of post parts P that protrude in the -Z direction. Part of these post parts P are the plurality of light-emitting elements 23.

The light-emitting elements 23 are provided as part of the laminated film 22 on the top surface S1 of the substrate 21. The light-emitting element 23 according to the present embodiment has the VCSEL structure, and emits light in the +Z direction. As illustrated in B of Fig. 3, the light emitted from the light-emitting element 23 transmits in the substrate 21 from the top surface S1 to the back surface S2 of the substrate 21, and enters the above-described correction lenses 16 from the substrate 21. Thus, the LD chip 11 according to the present embodiment is a back surface emission type VCSEL chip. The light-emitting element 23 is also referred to as a mesa part.

Each light-emitting element 23 is provided between an unillustrated anode wiring (anode electrode) and cathode wiring (cathode electrode). Each light-emitting element 23 emits light when the current flows between the anode wiring and the cathode wiring. Further details of the anode wiring and the cathode wiring will be described later.

Fig. 4 is a circuit diagram illustrating the structure of the light-emitting device 1a according to the first embodiment.

Fig. 4 illustrates the plurality of light-emitting elements 23 disposed in a two-dimensional array, and a plurality of transistors 24 electrically connected to these light-emitting elements 23. These transistors 24 are, for example, an N-type MOS transistor. Fig. 4 illustrates, for example, the 9×9 light-emitting elements 23, and the 9×9 transistors 24. Hence, the light-emitting device 1a illustrated in Fig. 4 include 9ch × 9ch light-emitting element arrays.

As illustrated in Fig. 4, the light-emitting device 1a according to the present embodiment further includes a first anode wiring 31, a second anode wiring 32, a third anode wiring 33, a plurality of first capacitors 34, a plurality of second capacitors 35, a plurality of third capacitors 36, a first selection circuit 37, a second selection circuit 38, a third selection circuit 39, a plurality of cathode wirings 41, and a plurality of gate wirings 42. The first to third anode wirings 31 to 33 are examples of the first terminal wirings according to the present disclosure, and the cathode wiring 41 is an example of a second terminal wiring according to the present disclosure. Furthermore, the first to third capacitors 34 to 36 are examples of first to Nth capacitors according to the present disclosure, and the first to third selection circuits 37 to 39 are examples of the first to Nth selection circuits (N represents an integer equal to or more than two) according to the present disclosure. Fig. 4 illustrates an example where N is three.

The first anode wiring 31 includes a plurality of first horizontal wirings 31a extending in the horizontal direction (X direction), and a plurality of first vertical wirings 31b extending in the vertical direction (Y direction). Similarly, the second anode wiring 32 includes a plurality of second horizontal wirings 32a extending in the horizontal direction, and a plurality of second vertical wirings 32b extending in the vertical direction. Similarly, the third anode wiring 33 includes a plurality of third horizontal wirings 33a extending in the horizontal direction, and a plurality of third vertical wirings 33b extending in the vertical direction. Fig. 4 illustrates, for example, the five first horizontal wirings 31a, the five first vertical wirings 31b, the five second horizontal wirings 32a, the five second vertical wirings 32b, the five third horizontal wirings 33a, and the five third vertical wirings 33b. These wirings are examples of M sets (M represents an integer equal to or more than two) of the first to Nth horizontal wirings and the first to Nth vertical wirings according to the present disclosure. Fig. 4 illustrates an example where M is five. The number of the light-emitting elements 23 illustrated in Fig. 4 is N(M-2)×N(M-2) when expressed using N and M.

Note that the first to third anode wirings 31 to 33 may include Ma sets of the first to Nth horizontal wirings, and Mb sets of the first to Nth vertical wirings (Ma and Mb represent integers that satisfy Ma ≠ Mb and equal to two or more). In this case, the number of the light-emitting elements 23 of the light-emitting device 1a is N(Ma-2)×N(Mb-2).

The first selection circuit 37 includes transistors 37a and 37b. Similarly, the second selection circuit 38 includes transistors 38a and 38b. Similarly, the third selection circuit 39 includes transistors 39a and 39b. The transistors 37a, 38a, and 39a are, for example, P-type MOS transistors. The transistors 37b, 38b, and 39b are, for example, N-type MOS transistors. The transistors 37a, 38a, and 39a are examples of first switches according to the present disclosure. The transistors 37b, 38b, and 39b are examples of second switches according to the present disclosure.

### [First to Third Anode Wirings 31 to 33]

Fig. 4 illustrates the first anode wiring 31 as a thick solid line, the second anode wiring 32 as a thick broken line, and the third anode wiring 33 as a thin solid line to distinguish the first to third anode wirings 31 to 33 from each other.

The first anode wiring 31 has a structure that the plurality of first horizontal wirings 31a and the plurality of first vertical wirings 31b are disposed in a mesh. These first horizontal wirings 31a and the first vertical wirings 31b are electrically connected with each other at points at which the first horizontal wirings 31a and the first vertical wirings 31b intersect. Similarly, the second anode wiring 32 includes the plurality of second horizontal wirings 32a and the plurality of second vertical wirings 32b electrically connected with each other, and the third anode wiring 33 includes the plurality of third horizontal wirings 33a and the plurality of third vertical wirings 33b electrically connected with each other. On the other hand, the first to third anode wirings 31 to 33 are electrically insulated from each other.

The first to third horizontal wirings 31a to 33a extend in the X direction (horizontal direction), and are adjacent to each other in the Y direction (vertical direction). The first to third horizontal wirings 31a to 33a linearly extend in the X direction in Fig. 4, yet may extend in a curved shape in the X direction. That is, the first to third horizontal wirings 31a to 33a may include bent portions.

On the other hand, the first to third vertical wirings 31b to 33b extend in the Y direction, and are adjacent to each other in the X direction. The first to third vertical wirings 31b to 33b linearly extend in the Y direction in Fig. 4, yet may extend in a curved shape in the Y direction. That is, the first to third vertical wirings 31b to 33b may also include bent portions.

Fig. 4 illustrates five sets of the first to third horizontal wirings 31a to 33a. In Fig. 4, a first set, a second set, a third set, a fourth set, and a fifth set of the first to third horizontal wirings 31a to 33a are aligned in order from the top to the bottom. In each set, the first horizontal wiring 31a, the second horizontal wiring 32a, and the third horizontal wiring 33a are aligned in order from the top to the bottom. The first set of the first to third horizontal wirings 31a to 33a, and the fifth set of the first to third horizontal wirings 31a to 33a are disposed sandwiching the 9×9 light-emitting elements 23. Each of the second to fourth sets of the first to third horizontal wirings 31a to 33a is disposed along one row of the (nine) light-emitting elements 23.

Fig. 4 further illustrates the five sets of the first to third vertical wirings 31b to 33b. In Fig. 4, the first set, the second set, the third set, the fourth set, and the fifth set of the first to third vertical wirings 31b to 33b are aligned in order from the left to the right. In each set, the first vertical wiring 31b, the second vertical wiring 32b, and the third vertical wiring 33b are aligned in order from the left to the right. The first set of the first to third vertical wirings 31b to 33b, and the fifth set of the first to third vertical wirings 31b to 33b are disposed sandwiching the 9×9 light-emitting elements 23. Each of the second to fourth sets of the first to third vertical wirings 31b to 33b is disposed along one column of the (nine) light-emitting elements 23.

The anode of each light-emitting element 23 is electrically connected to one of the first to third vertical wirings 31b to 33b. For example, the light-emitting elements 23 of the leftmost column are electrically connected to the first vertical wiring 31b of the second set of the first to third vertical wirings 31b to 33b. Furthermore, the light-emitting elements 23 of the rightmost column are electrically connected to the third vertical wiring 33b of the fourth set of the first to third vertical wirings 31b to 33b. Note that the anode of each light-emitting element 23 may be electrically connected to one of the first to third horizontal wirings 31a to 33a instead of being electrically connected to one of the first to third vertical wirings 31b to 33b. The anode is an example of a first terminal according to the present disclosure.

### [Cathode Wiring 41]

Each cathode wiring 41 extends in the X direction, and is electrically connected to cathodes of the three light-emitting elements 23. More specifically, each cathode wiring 41 is electrically connected to the one light-emitting element 23 electrically connected to the first vertical wiring 31b, the one light-emitting element 23 electrically connected to the second vertical wiring 32b, and the one light-emitting element 23 electrically connected to the third vertical wiring 33b. These three light-emitting elements 23 are adjacent to each other in the X direction. Fig. 4 illustrates the 27 cathode wirings 41 for the 81 light-emitting elements 23. The cathode is an example of a second terminal according to the present disclosure.

Each light-emitting element 23 is provided between a corresponding anode wiring, that is, one of the first to third anode wirings 31 to 33, and a corresponding cathode wiring, that is, one of the plurality of cathode wirings 41. Each light-emitting element 23 emits light when the current flows between the corresponding anode wiring and the corresponding cathode wiring.

### [Gate Wiring 42]

Each gate wiring 42 extends in the X direction, and is electrically connected to gates of the three transistors 24. Sources of these three transistors 24 are electrically connected to a ground wiring (GND), and drains of these three transistors 24 are electrically connected to the same one cathode wiring 41. These three transistors 24 form one drive circuit E. Fig. 4 illustrates the 27 gate wirings 42 for the 81 transistors 24.

Each drive circuit E is electrically connected to cathodes of the three light-emitting elements 23 via the one cathode wiring 41. Each drive circuit (output stage) E is used to drive the light-emitting elements 23, and produce (output) light from the light-emitting elements 23. When, for example, the certain light-emitting element 23 is caused to produce light, a predetermined signal is applied to the gate wiring 42 of the drive circuit E for this light-emitting element 23. Consequently, the source and the drain of each transistor 24 in this drive circuit E conduct, so that it is possible to cause the current to flow to this light-emitting element 23. When the current flows to this light-emitting element 23, this light-emitting element 23 produces light. The light-emitting device 1a illustrated in Fig. 4 includes the 27 drive circuits E for the 81 light-emitting elements 23.

### [First to Third Selection Circuits 37 to 39]

Each of the first to third selection circuits 37 to 39 is electrically connected to the first to third horizontal wirings 31a to 33a of the first to third anode wirings 31 to 33. The first selection circuit 37 is used to select the light-emitting element 23 electrically connected to the first anode wiring 31 as the light-emitting element 23 that is caused to produce light. The second selection circuit 38 is used to select the light-emitting element 23 electrically connected to the second anode wiring 32 as the light-emitting element 23 that is caused to produce light. The third selection circuit 39 is used to select the light-emitting element 23 electrically connected to the third anode wiring 33 as the light-emitting element 23 that is caused to produce light. Each of the first to third selection circuits 37 to 39 may be electrically connected to the first to third vertical wiring 31b to 33b of the first to third anode wirings 31 to 33 instead of the first to third horizontal wirings 31a to 33a of the first to third anode wirings 31 to 33.

The first selection circuit 37 includes the transistor 37a that includes the source electrically connected to a power supply wiring (VDD), and the transistor 37b that includes the source electrically connected to the ground wiring. The drain of the transistor 37a and the drain of the transistor 37b are electrically connected to the first anode wiring 31. The first selection circuit 37 is electrically connected to each first capacitor 34 via the first anode wiring 31.

The transistor 37a is used to accumulate a charge in each first capacitor 34. The transistor 37b is used to discharge a charge from each first capacitor 34. When a predetermined signal is applied to the gate of the transistor 37a, the charge is accumulated in each first capacitor 34. When a predetermined signal is applied to the gate of the transistor 37b, the charge is discharged from each first capacitor 34. Consequently, according to the present embodiment, the first selection circuit 37 selectively accumulates the charge in the first capacitor 34 of the first to third capacitors 34 to 36, so that it is possible to cause the current to flow to each light-emitting element 23 electrically connected to the first anode wiring 31.

The structures of the second and third selection circuits 38 and 39 are the same as the structure of the first selection circuit 37 as illustrated in Fig. 4. Consequently, according to the present embodiment, the second selection circuit 38 accumulates the charge in each second capacitor 35, so that it is possible to cause the current to flow to each light-emitting element 23 electrically connected to the second anode wiring 32. Furthermore, according to the present embodiment, the third selection circuit 39 accumulates the charge in each third capacitor 36, so that it is possible to cause the current to flow to each light-emitting element 23 electrically connected to the third anode wiring 33.

### [First to Third Capacitors 34 to 36]

Each of the first to third capacitors 34 to 36 is electrically connected to the first to third anode wirings 31 to 33. Each first capacitor 34 accumulates the charge to be supplied to the light-emitting element 23 electrically connected with the first anode wiring 31. Each second capacitor 35 accumulates the charge to be supplied to the light-emitting element 23 electrically connected with the second anode wiring 32. Each third capacitor 36 accumulates the charge to be supplied to the light-emitting element 23 electrically connected with the third anode wiring 33. According to the present embodiment, by supplying the charge from the first to third capacitors 34 to 36 to each light-emitting element 23, it is possible to cause the current to flow to each light-emitting element 23. Each of the first to third capacitors 34 to 36 includes one electrode electrically connected to one of the first to third anode wirings 31 to 33, and an other electrode electrically connected to the ground wiring.

The light-emitting device 1a illustrated in Fig. 4 includes a light-emitting element array including the 9×9 light-emitting elements 23 disposed in the two-dimensional array. The shape of this light-emitting element array has a substantially square shape in plan view as illustrated in Fig. 4. The light-emitting device 1a illustrated in Fig. 4 includes four sets of the first to third capacitors 34 to 36 near the four sides of this square shape. More specifically, the light-emitting device 1a illustrated in Fig. 4 includes the first set of the first to third capacitors 34 to 36 near the upper side of the square shape, the second set of the first to third capacitors 34 to 36 near the right side of the square shape, the third set of the first to third capacitors 34 to 36 near the lower side of the square shape, and the fourth set of the first to third capacitors 34 to 36 near the left side of the square shape. These first to third capacitors 34 to 36 are examples of K sets (K represents an integer equal to or more than two) of first to Nth capacitors according to the present disclosure. Fig. 4 illustrates an example where K is four.

The first to third capacitors 34 to 36 of the first set and the third set are electrically connected to the first to third horizontal wirings 31a to 33a of the first to third anode wirings 31 to 33, respectively. On the other hand, the first to third capacitors 34 to 36 of the second set and the fourth set are electrically connected to the first to third vertical wirings 31b to 33b of the first to third anode wirings 31 to 33, respectively. As a result, the first to third capacitors 34 to 36 illustrated in Fig. 4 are electrically connected to the first to third anode wirings 31 to 33, respectively.

In each set, the first to third capacitors 34 to 36 are aligned in order clockwise. For example, the first capacitor 34, the second capacitor 35, and the third capacitor 36 of the first set are disposed on the left side, the center, and the right side, respectively, near the upper side of the square shape. Furthermore, the first capacitor 34, the second capacitor 35, and the third capacitor 36 of the second set are disposed on the upper side, the center, and the lower side, respectively, near the right side of the square shape. As a result, the four sets of the first to third capacitors 34 to 36 illustrated in Fig. 4 are symmetrically disposed with respect to the center of the square shape. The center of the square shape is substantially located at the position of the light-emitting element 23 in the fifth row and the fifth column of the 9×9 light-emitting elements 23. In Fig. 4, the four sets of the first to third capacitors 34 to 36 are four-fold rotational symmetry (90-degree rotational symmetry).

According to the present embodiment, it is possible to set, for example, an average distance between each light-emitting element 23 and the four corresponding capacitors to a value close to an average distance between the other light-emitting element 23 and the four corresponding capacitors.

For example, the light-emitting element 23 at the upper left end is close to the first capacitor 34 on the upper side, yet is distant from the first capacitor 34 on the lower side. On the other hand, the light-emitting element 23 at the lower right end is close to the third capacitor 36 on the right side, yet is distant from the third capacitor 36 on the left side. Hence, the average distance between the light-emitting element 23 at the upper left end and the four first capacitors 34 takes a value close to the average distance between the light-emitting element 23 at the lower right end and the four third capacitors 36. The same also applies to the other 79 light-emitting elements 23. Consequently, it is possible to reduce a difference between the impedances of the wirings of the different light-emitting elements 23 for an anode wiring between each light-emitting element 23 and the four corresponding capacitors.

The light-emitting device 1a according to the present embodiment may include the first to third capacitors 34 to 36 only near the one side, the two sides, or the three sides of the four sides of the square shape. In this regard, it is also desirable to dispose the first to third capacitors 34 to 36 in this case symmetrically with respect to the center of the square shape or in a shape close to a symmetrical shape. Hence, the light-emitting device 1a according to the present embodiment desirably include the first to third capacitors 34 to 36 near the two or more sides of the four sides of the square shape. By, for example, disposing the two sets of the first to third capacitors 34 to 36 near the upper side and the lower side of the square shape, it is possible to achieve two-fold rotational symmetry (180-degree rotational symmetry) arrangement.

Fig. 5 is a circuit diagram illustrating the structure of the light-emitting device 1a according to a comparative example of the first embodiment.

The light-emitting device 1a according to this comparative example includes a light-emitting element array including the 9×9 light-emitting elements 23 disposed in a two-dimensional array similarly to the light-emitting device 1a according to the present embodiment. In this regard, the light-emitting device 1a according to this comparative example includes a capacitor array including the 9×9 capacitors 34 disposed in a two-dimensional array, and the capacitor array is disposed on the right side of the light-emitting element array. Each light-emitting element 23 according to this comparative example is electrically connected to the corresponding capacitor 34 via the corresponding anode wiring 31. Furthermore, the 9×9 light-emitting elements 23 according to this comparative example are electrically connected to the common drive circuit E (transistor 24) via the common cathode wiring 41. The drive circuit E according to this comparative example is disposed on the left side of the light-emitting element array.

This comparative example has a problem that the number of the anode wirings 31 is large, and the length of the anode wiring 31 is long on average. Furthermore, there is a problem that the light-emitting device 1a according to this comparative example has both of the short anode wiring 31 and the long anode wirings 31. As a result, there is a problem that the impedance of each anode wiring 31 becomes great, and a difference between the impedances of the anode wirings 31 becomes great. Furthermore, there is also a problem that the length of the cathode wiring 41 between each of the light-emitting element 23 and the drive circuit E greatly differs per light-emitting element 23.

When the impedance of each anode wiring 31 is great, there are a concern that the intensity of light emitted from each light-emitting element 23 becomes insufficient, or a concern that a power consumption amount for driving each light-emitting element 23 becomes large. Furthermore, when the difference between the impedances of the anode wirings 31 becomes great, there is a concern that a difference between the intensities of light emitted from the different light-emitting elements 23 becomes great. As a result, there is a concern that performance of the ranging device 1 lowers.

On the other hand, the light-emitting device 1a according to the present embodiment includes the first to third anode wirings 31 to 33 that are disposed in the mesh, and the first to third capacitors 34 to 36 that are electrically connected to the first to third anode wirings 31 to 33 so as to be disposed symmetrically. Consequently, according to the present embodiment, it is possible to prevent the problems of the above impedances and impedance difference, and improve the performance of the ranging device 1. Furthermore, according to the present embodiment, it is also possible to prevent the problem related to the cathode wirings 41 by disposing the cathode wirings 41 every three light-emitting elements 23.

Fig. 6 shows a graph for describing performance of the light-emitting device 1a according to the first embodiment.

The vertical axis in Fig. 6 indicates an LDD output current (an output current from the LDD substrate 12 to each light-emitting element 23), and the horizontal axis in Fig. 6 indicates a time. Fig. 6 illustrates the waveform of the LDD output current. Fig. 6 further illustrates a peak value Ipeak of the LDD output current, a pulse width W of the LDD output current, and a half width W' of the LDD output current.

To improve the performance of the ranging device 1, it is desirable to increase the peak value Ipeak, and shorten the pulse width W (or the half width W'). According to the present embodiment, by reducing the impedance of each wiring and the difference between the impedances of the wirings, it is possible to increase the peak value Ipeak and shorten the pulse width W (or the half width W').

Fig. 7 is a cross-sectional view and a plan view illustrating the structure of the light-emitting device 1a according to the first embodiment. Similar to A of Fig. 3, A of Fig. 7 illustrates an XZ cross section of the light-emitting device 1a. B of Fig. 7 illustrates a planar structure of the light-emitting device 1a illustrated in A of Fig. 7.

The light-emitting device 1a according to the present embodiment may have the structure illustrated in A and B of Fig. 7 instead of the structure illustrated in A of Fig. 3. In A and B of Fig. 7, the light-emitting device 1a according to the present embodiment includes the LD chip 11, the LDD substrate 12, the mounting substrate 13, and the four sets of the first to third capacitors 34 to 36.

This mounting substrate 13 includes an insulating substrate 51, an insulating film 52, a wiring layer 53, an insulating film 54, a wiring layer 55, and a plurality of wirings 56. The LDD substrate 12 illustrated in A of Fig. 7 is provided in the insulating substrate 51. The insulating film 52 and the wiring layer 53 are formed in order on the upper surface of the insulating substrate 51. The insulating film 54 and the wiring layer 55 are formed in order on the lower surface of the insulating substrate 51. The LD chip 11 illustrated in A of Fig. 7 is provided on the wiring layer 53. Each wiring 56 is formed in the insulating substrate 51, the insulating film 52, and the wiring layer 53, and electrically connects the LD chip 11 and the LDD substrate 12.

Each of the first to the third capacitors 34 to 36 is disposed above the wiring layer 53 with a plurality of solder balls 57 interposed therebetween, and is electrically connected to the LD chip 11 and the LDD substrate 12 via these solder balls 57 and the wiring layer 53.

In B of Fig. 7, the shapes of the LD chip 11 and the LDD substrate 12 are square shapes in plan view. The light-emitting device 1a illustrated in B of Fig. 7 includes the four sets of the first to third capacitors 34 to 36 near the four sides of the square shape that is the planar shape of the LD chip 11. These first to third capacitors 34 to 36 are symmetrically disposed with respect to the center of this square shape. Note that the light-emitting device 1a illustrated in B of Fig. 7 may include these first to third capacitors 34 to 36 only near the one side, the two sides, or the three sides of the four sides of this square shape. In this regard, it is also desirable to dispose the first to third capacitors 34 to 36 in this case symmetrically with respect to the center of this square shape or in a shape close to a symmetrical shape. Hence, the light-emitting device 1a illustrated in B of Fig. 7 desirably includes these first to third capacitors 34 to 36 near the two or more sides of the four sides of this square shape.

In A and B of Fig. 7, the plurality of light-emitting elements 23, the plurality of transistors 24, and the first to third selection circuits 37 to 39 (Fig. 4) are provided in, for example, the LD chip 11 or the LDD substrate 12. For example, the light-emitting elements 23 are provided in the LD chip 11 similarly to the light-emitting elements 23 illustrated in B of Fig. 3. On the other hand, the transistor 24 and the first to third selection circuits 37 to 39 may be provided in the LD chip 11 or may be provided in the LDD substrate 12. Note that the first to third capacitors 34 to 36 may be disposed on the LD chip 11 or the LDD substrate 12.

Fig. 8 is a perspective view schematically illustrating the structure of the light-emitting device 1a according to the first embodiment.

Fig. 8 schematically illustrates the shapes of the LD chip 11 and the LDD substrate 12 illustrated in A and B of Fig. 7. Fig. 8 further schematically and partially illustrates the first to third horizontal wirings 31a to 33a and the first to third vertical wirings 31b to 33b of the above-described first to third anode wirings 31 to 33, and the plurality of cathode wirings 41. As illustrated in Fig. 8, the first to third horizontal wirings 31a to 33a and the first to third vertical wirings 31b to 33b have mesh-shaped structures.

Note that the first to third anode wirings 31 to 33 and the cathode wirings 41 illustrated in Fig. 8 are drawn between the LD chip 11 and the LDD substrate 12, yet may be disposed in the LD chip 11, may be disposed in the LDD substrate 12, or may be disposed between the LD chip 11 and the LDD substrate 12.

Next, the light-emitting device 1a according to various modification examples of the present embodiment will be described with reference to Figs. 9 to 18. The contents described with reference to Figs. 1 to 8 are also applied to these modification examples.

### (3) Light-Emitting Device 1a According to First Modification Example

Fig. 9 is a circuit diagram illustrating the structure of the light-emitting device 1a according to the first modification example of the first embodiment.

The light-emitting device 1a illustrated in Fig. 9 has the same structure as that of the light-emitting device 1a illustrated in Fig. 4. Here, the light-emitting elements 23 denoted by reference numerals P1 to P6 will be described.

The light-emitting element 23 denoted by reference numeral P1 is electrically connected to the first anode wiring 31 and the cathode wiring 41 at the upper left end. When only this light-emitting element 23 is driven (individually driven), only the first selection circuit 37 of the first to third selection circuits 37 to 39 is turned on, and only the drive circuit E for the cathode wiring 41 at the upper left end is turned on. As a result, the charge is accumulated only in the first capacitor 34 of the first to third capacitors 34 to 36, and only the three light-emitting elements 23 electrically connected to the cathode wiring 41 at the upper left end are driving targets. Thus, the current flows only to the light-emitting element 23 denoted by reference numeral P1, and only this light-emitting element 23 emits light.

The light-emitting elements 23 denoted by reference numerals P2 to P4 are electrically connected to the first anode wiring 31, and are electrically connected to the respectively different cathode wirings 41. When only these light-emitting elements 23 are driven (simultaneously driven), only the first selection circuit 37 of the first to third selection circuits 37 to 39 is turned on, and only the drive circuits E for these cathode wirings 41 are turned on. As a result, the charge is accumulated only in the first capacitor 34 of the first to third capacitors 34 to 36, and only the nine light-emitting elements 23 electrically connected to these cathode wirings 41 are driving targets. Thus, the current flows only to the light-emitting elements 23 denoted by reference numerals P2 to P4, and only these light-emitting elements 23 emit light.

The light-emitting elements 23 denoted by reference numerals P5 and P6 are electrically connected to the first and second anode wirings 31 and 32, respectively, and are electrically connected to the same one cathode wiring 41. When only these light-emitting elements 23 are driven (simultaneously driven), only the first and second selection circuits 37 and 38 of the first to third selection circuits 37 to 39 are turned on, and only the drive circuit E for this cathode wiring 41 is turned on. As a result, the charges are accumulated only in the first and second capacitors 34 and 35 of the first to third capacitors 34 to 36, and only the three light-emitting elements 23 electrically connected to this cathode wiring 41 are driving targets. Thus, the currents flow only to the light-emitting elements 23 denoted by reference numerals P5 and P6, and only these light-emitting elements 23 emit light.

Note that individual driving of the light-emitting element 23 denoted by reference numeral P1 is also applicable to the other 80 light-emitting elements 23. The same also applies to simultaneous driving of the light-emitting elements 23 denoted by reference numerals P2 to P6. The number of the light-emitting elements 23 that are simultaneous driving targets may be any number. These individual driving and simultaneous driving are controlled by, for example, the control unit 9 illustrated in Fig. 1.

### (4) Light-Emitting Device 1a According to Second Modification Example

Fig. 10 is a circuit diagram illustrating the structure of the light-emitting device 1a according to the second modification example of the first embodiment.

The light-emitting device 1a according to this modification example includes first to third cathode wirings 31' to 33' at positions of the first to third anode wirings 31 to 33 illustrated in Fig. 4, and includes a plurality of anode wirings 41' at positions of the plurality of cathode wirings 41, and does not include the plurality of gate wirings 42. Furthermore, the first to third cathode wirings 31' to 33' include first to third horizontal wirings 31a' to 33a' and first to third vertical wirings 31b' to 33b', respectively, similarly to the first to third anode wirings 31 to 33. The first to third cathode wirings 31' to 33' are examples of first terminal wirings according to the present disclosure. The anode wirings 41' are examples of second terminal wirings according to the present disclosure.

Each light-emitting element 23 according to this modification example includes a cathode electrically connected to one of the first to third cathode wirings 31' to 33', and an anode electrically connected to one of the plurality of anode wirings 41'.

The light-emitting device 1a according to this modification example includes first to third transistors 61 to 63 at positions of the first to third capacitors 34 to 36 illustrated in Fig. 4. The first to third transistors 61 to 63 are, for example, N-type MOS transistors. The gates of the first to third transistors 61 to 63 are electrically connected to first to third gate wirings 64 to 66. Each of the first to third transistors 61 to 63 includes a drain electrically connected to one of the first to third cathode wirings 31' to 33', and a source electrically connected to the ground wiring. Each of the first to third transistors 61 to 63 forms the drive circuit E. The drive circuits E including the first to third transistors 61 to 63 are examples of first to Nth drive circuits.

The light-emitting device 1a according to this modification example further includes a plurality of capacitors 67 at the positions of the plurality of transistors 24 illustrated in Fig. 4. Each of these capacitors 67 includes one electrode electrically connected to one of the plurality of anode wirings 41', and an other electrode electrically connected to the ground wiring.

The light-emitting device 1a according to this modification example further includes a plurality of selection circuits 68 instead of the first to third selection circuits 37 to 39. Each selection circuit 68 is electrically connected to the one corresponding anode wiring 41'. Each selection circuit 68 includes a transistor 68a that includes a source electrically connected to a power supply wiring, and a transistor 68b that includes a source electrically connected to the ground wiring. The drain of the transistor 68a and the drain of the transistor 68b are electrically connected to the cathode wiring 41. Each selection circuit 68 is electrically connected to the one corresponding capacitor 67 via the anode wiring 41'. The transistor 68a is, for example, a P-type MOS transistor. The transistor 68b is, for example, an N-type MOS transistor. The transistor 68a is an example of the first switch according to the present disclosure. The transistor 68b is an example of the second switch according to the present disclosure.

The functions of the capacitors 67, the transistors 68a, and the transistors 68b are the same as the functions of the first to third capacitors 34 to 36, the transistors 37a to 39a, and the transistors 37b to 39b. The transistor 68a can accumulate a charge in the corresponding capacitor 67. The transistor 68b can discharge a charge from the corresponding capacitor 67. By supplying the charge to the light-emitting element 23 via the anode wiring 41', the capacitor 67 can cause the current to flow to the light-emitting element 23.

Furthermore, the functions of the first to third transistors 61 to 63 and the drive circuits E thereof are the same as the functions of the transistors 34 and the drive circuits E thereof. Each of the first to third transistors 61 to 63 can drive the light-emitting element 24 electrically connected to the first to third cathode wirings 31' to 33'.

The light-emitting device 1a according to this modification example can implement the same control as that of the light-emitting device 1a according to the first embodiment using a different structure from that of the light-emitting device 1a according to the first embodiment.

### (5) Light Emitting-Device 1a According to Third Modification Example

Fig. 11 is a circuit diagram illustrating the structure of the light-emitting device 1a according to the third modification example of the first embodiment.

The light-emitting device 1a according to this modification example includes the first to third cathode wirings 31' to 33' at positions of the first to third anode wirings 31 to 33 illustrated in Fig. 4, includes a plurality of anode wirings 41' at the positions of the plurality of cathode wirings 41, and includes a plurality of gate wirings 42' at the positions of the plurality of gate wirings 42. Furthermore, the first to third cathode wirings 31' to 33' include the first to third horizontal wirings 31a' to 33a' and the first to third vertical wirings 31b' to 33b', respectively, similarly to the first to third anode wirings 31 to 33. The first to third cathode wirings 31' to 33' are examples of first terminal wirings according to the present disclosure. The anode wirings 41' are examples of second terminal wirings according to the present disclosure.

Each light-emitting element 23 according to this modification example includes a cathode electrically connected to one of the first to third cathode wirings 31' to 33', and an anode electrically connected to one of the plurality of anode wirings 41'. Each transistor 24 according to this modification example includes a gate electrically connected to one of the plurality of gate wirings 42', a drain electrically connected to one of the plurality of anode wirings 41', and a source electrically connected to the power supply wiring. Each transistor 24 according to this modification example is, for example, a P-type MOS transistor. The first to third capacitors 34 to 36 and the first to third selection circuits 37 to 39 according to this modification example are electrically connected to the first to third cathode wirings 31' to 33', respectively.

The light-emitting device 1a according to this modification example can implement the same control as that of the light-emitting device 1a according to the first embodiment using a different structure from that of the light-emitting device 1a according to the first embodiment.

### (6) Light Emitting-Device 1a According to Fourth Modification Example

Fig. 12 is a circuit diagram illustrating the structure of the light-emitting device 1a according to the fourth modification example of the first embodiment.

The light-emitting device 1a according to this modification example includes six sets of the first to third capacitors 34 to 36 instead of the four sets of the first to third capacitors 34 to 36 illustrated in Fig. 4. Note that the first to third capacitors 34 to 36 according to this modification example are disposed in the LD chip 11 (or in the LDD substrate 12), and are disposed near the light-emitting element 23. In this modification example, each first capacitor 34 is electrically connected to one of the horizontal wirings 31a, each second capacitor 35 is electrically connected to one of the horizontal wirings 32a, and each third capacitor 36 is electrically connected to one of the horizontal wirings 33a.

The light-emitting device 1a according to this modification example can implement the same control as that of the light-emitting device 1a according to the first embodiment using a different structure from that of the light-emitting device 1a according to the first embodiment.

### (7) Light Emitting-Device 1a According to Fifth Modification Example

Fig. 13 is a circuit diagram illustrating the structure of the light-emitting device 1a according to the fifth modification example of the first embodiment.

The light-emitting device 1a according to this modification example does not include the first to third capacitors 34 to 36. The light-emitting device 1a according to this modification example accumulates the charge to be supplied to each light-emitting device 1a in a parasitic capacitance to be described later instead of the first to third capacitors 34 to 36.

Fig. 14 is another circuit diagram illustrating the structure of the light-emitting device 1a according to the fifth modification example of the first embodiment.

Fig. 14 illustrates one set of the light-emitting element 23 and the transistor 24 included in the light-emitting device 1a according to this modification example. Fig. 14 further illustrates a parasitic capacitance 23' of the light-emitting element 23 and a parasitic capacitance 24' of the transistor 24. The light-emitting device 1a according to this modification example accumulates the charge to be supplied to each light-emitting device 1a in these parasitic capacitances 23' and 24'. Consequently, it is possible to cause the current to flow to each light-emitting element 23, and cause each light-emitting element 23 to emit light. Accumulation in the parasitic capacitances 23' and 24' is controlled by the first to third selection circuits 37 to 39.

The light-emitting device 1a according to this modification example can implement the same control as that of the light-emitting device 1a according to the first embodiment using a different structure from that of the light-emitting device 1a according to the first embodiment.

### (8) Light Emitting-Device 1a According to Sixth Modification Example

Fig. 15 is a circuit diagram illustrating various examples of the structure of the light-emitting device 1a according to the sixth modification example of the first embodiment.

The light-emitting device 1a according to this modification example has the structure illustrated in Fig. 4 similarly to the light-emitting device 1a according to the first embodiment. In this regard, while each drive circuit E according to the first embodiment has the structure illustrated in A of Fig. 15, each drive circuit E according to this modification example has the structures illustrated in one of B to D of Fig. 15.

The drive circuit E illustrated in B of Fig. 15 includes the three transistors 24 electrically connected to the cathode wiring 41, and three transistors 25 electrically connected to these transistors 24. The transistors 24 and 25 illustrated in B of Fig. 15 are, for example, N-type MOS transistors. Gates of these transistors 24 are electrically connected to the common gate wiring 42, and gates of these transistors 25 are electrically connected to a common gate wiring 43. The transistors 24 and 25 are examples of the first and second transistors according to the present disclosure.

Each transistor 24 is used to select the light-emitting element 23 that is caused to produce light. Each transistor 25 is used as a current source. When, for example, the certain light-emitting element 23 is caused to produce light, a predetermined signal is applied to the gate wiring 42 of the drive circuit E for this light-emitting element 23, and a predetermined signal (DC bias voltage) is applied to the gate wiring 43 of the drive circuit E for this light-emitting element 23. Consequently, the source and the drain of each transistor 24 in this drive circuit E conduct each other, and the source and the drain of each transistor 25 in this drive circuit E conduct each other, so that it is possible to cause the current to flow to this light-emitting element 23. In this case, each transistor 25 functions as the current source.

The drive circuit E illustrated in C of Fig. 15 includes the three transistors 24 electrically connected to the cathode wiring 41. The transistor 24 illustrated in C of Fig. 15 is, for example, an NPN-type bipolar transistor. In this case, the wiring 42 is a "base wiring" instead of the "gate wiring". The operation of the drive circuit E illustrated in C of Fig. 15 is the same as that of the drive circuit E illustrated in A of Fig. 15.

The drive circuit E illustrated in D of Fig. 15 includes the three transistors 24 electrically connected to the cathode wiring 41, and the three transistors 25 electrically connected to these transistors 24. The transistors 24 and 25 illustrated in D of Fig. 15 are, for example, NPN-type bipolar transistors. In this case, the wirings 42 and 43 are "base wirings" instead of the "gate wirings". The operation of the drive circuit E illustrated in D of Fig. 15 is the same as that of the drive circuit E illustrated in B of Fig. 15.

The light-emitting device 1a according to this modification example can implement the same control as that of the light-emitting device 1a according to the first embodiment using a different structure from that of the light-emitting device 1a according to the first embodiment.

### (9) Light Emitting-Device 1a According to Seventh Modification Example

Fig. 16 is a circuit diagram illustrating the structure of the light-emitting device 1a according to the seventh modification example of the first embodiment.

The light-emitting device 1a according to this modification example includes first to third voltage detection circuits 71 to 73 in addition to the components illustrated in Fig. 4. The first voltage detection circuit 71 is electrically connected to the first horizontal wiring 31a of the first anode wiring 31, and the gate of the transistor 37a. The second voltage detection circuit 72 is electrically connected to the second horizontal wiring 32a of the second anode wiring 32, and the gate of the transistor 38a. The third voltage detection circuit 73 is electrically connected to the third horizontal wiring 33a of the third anode wiring 33, and the gate of the transistor 39a.

The first voltage detection circuit 71 detects the voltage of the first anode wiring 31 from the first horizontal wiring 31a of the first anode wiring 31. This voltage indicates the charge amount accumulated in the four first capacitors 34. Hence, the first voltage detection circuit 71 controls a gate voltage of the transistor 37a on the basis of the voltage detected from the first anode wiring 31. When, for example, the detected voltage is lower than a predetermined voltage, the transistor 37a is turned on to start accumulation of the charge. On the other hand, when the detected voltage is higher than the predetermined voltage, the transistor 37a is turned off to end accumulation of the charge. According to this modification example, by changing a value of this predetermined voltage, it is possible to change output power of the light-emitting device 1a. The value of this predetermined voltage is adjusted by, for example, the control unit 9 illustrated in Fig. 1.

Similarly, the second voltage detection circuit 72 detects the voltage of the second anode wiring 32, and controls a gate voltage of the transistor 38a on the basis of the detected voltage. The third voltage detection circuit 73 detects the voltage of the third anode wiring 33, and controls a gate voltage of the transistor 39a on the basis of the detected voltage.

Fig. 17 is a timing chart illustrating an operation of the light-emitting device 1a according to the seventh modification example of the first embodiment.

Curves A1 and A2 indicate gate voltages of anode side PMOSs, that is, the transistors 37a to 39a. A curve B indicates gate voltages of anode side NMOSs, that is, the transistors 37b to 39b. A curve C indicates gate voltages of cathode side NMOSs, that is, the transistors 24. Curves D1 and D2 indicate voltages (anode voltages) of the first to third anode wirings 31 and 32. Curves E1 and E2 indicate output currents (LDD output currents) from the LDD substrate 12 to each light-emitting element 23.

The curve A1 indicates a case where pulse widths of the gate voltages of the transistors 37a to 39a are short. In this case, at a low anode voltage, the transistors 37a to 39a are turned off (curve D1), and low power light emission can be obtained (curve E1).

The curve A2 indicates a case where the pulse widths of the gate voltages of the transistors 37a to 39a are long. In this case, at a high anode voltage, the transistors 37a to 39a are turned off (curve D2), and high power light emission can be obtained (curve E2).

Consequently, according to this modification example, it is possible to freely change output power of the light-emitting device 1a.

### (10) Light Emitting-Device 1a According to Eighth Modification Example

Fig. 18 is a cross-sectional view and a plan view illustrating the structure of the light-emitting device 1a according to the eighth modification example of the first embodiment.

The light-emitting device 1a according to this modification example has the structure illustrated in A and B of Fig. 18 instead of the structure illustrated in A and B of Fig. 7. A of Fig. 18 illustrates the XZ cross section of the light-emitting device 1a according to this modification example. B of Fig. 18 illustrates a planar structure of the light-emitting device 1a illustrated in A of Fig. 18.

In this modification example, the LDD substrate 12 is disposed above the wiring layer 53 with a plurality of solder balls 58 interposed therebetween, and is electrically connected with the first to third capacitors 34 to 36 via these solder balls 58 and the wiring layer 53. Furthermore, the LD chip 11 is stacked above the LDD substrate 12 with a plurality of bumps 59 interposed therebetween, and is electrically connected with the LDD substrate 12 via these bumps 59. These bumps 59 are formed of, for example, a metal such as gold (Au). The other structure of the light-emitting device 1a according to this modification example is the same as the structure illustrated in A and B of Fig. 7.

The light-emitting device 1a according to this modification example can implement the same control as that of the light-emitting device 1a according to the first embodiment using a different structure from that of the light-emitting device 1a according to the first embodiment.

As described above, the light-emitting device 1a according to the present embodiment includes the first to third anode wirings 31 to 33 that are disposed in the mesh, and the first to third capacitors 34 to 36 that are electrically connected to the first to third anode wirings 31 to 33 so as to be disposed symmetrically. Consequently, according to the present embodiment, it is possible to prevent the problems of the above-described impedances and impedance difference, and improve the performance of the ranging device 1. Furthermore, according to the present embodiment, it is also possible to prevent the problem related to the cathode wirings 41 by disposing the cathode wirings 41 every three light-emitting elements 23. Consequently, according to the present embodiment, it is possible to optimize the structures of the wirings for the light-emitting elements 23.

### (Second Embodiment)

Fig. 19 is a circuit diagram illustrating the structure of the light-emitting device 1a according to the second embodiment.

The light-emitting device 1a according to the present embodiment includes a fourth anode wiring 81, a plurality of fourth capacitors 82, and a fourth selection circuit 83 in addition to the components illustrated in Fig. 4. The fourth anode wiring 81 includes a plurality of fourth horizontal wirings 81a and a plurality of fourth vertical wirings 81b. The fourth selection circuit 83 includes transistors 83a and 83b. The first to fourth selection circuits 37, 38, 39, and 83 are examples of the first to Nth selection circuits according to the present disclosure. Fig. 19 illustrates an example where N is four.

Fig. 19 illustrates the first anode wiring 31 as the thick solid line, the second anode wiring 32 as the thick broken line, the third anode wiring 33 as the thin solid line, and the fourth anode wiring 81 as a thin broken line to distinguish the first to fourth anode wirings 31, 32, 33, and 81 from each other.

The light-emitting device 1a according to the present embodiment includes the 8×8 light-emitting elements 23 disposed in the two-dimensional array. Hence, the first to fourth anode wirings 31, 32, 33, and 81 according to the present embodiment includes four sets of the first to fourth horizontal wirings 31a, 32a, 33a, and 81a and the first to fourth vertical wiring 31b, 32b, 33b, and 81b. These wirings are examples of the M sets of the first to Nth horizontal wirings and the first to Nth vertical wirings according to the present disclosure. Fig. 19 illustrates an example where M is four. The number of the light-emitting elements 23 illustrated in Fig. 19 is N(M-2)×N(M-2). The light-emitting device 1a according to the present embodiment further includes the 8×8 transistors 24 electrically connected to these light-emitting elements 23.

The first to fourth capacitors 34, 35, 36, and 82 according to the present embodiment include the four sets of the first to fourth capacitors 34, 35, 36, and 82. Each set of the first to fourth capacitors 34, 35, 36, and 82 is disposed in order near one side of the light-emitting element array of the square shape. Hence, the first to fourth capacitors 34, 35, 36, and 82 according to the present embodiment are also symmetrically disposed with respect to this square shape. The first to fourth capacitors 34, 35, 36, and 82 are examples of the K sets of the first to Nth capacitors according to the present disclosure. Fig. 19 illustrates an example where K is four.

The structures and the functions of the fourth anode wiring 81, the fourth capacitor 82, and the fourth selection circuit 83 according to the present embodiment are the same as those of the first to third anode wirings 31 to 33, the first to third capacitors 34 to 36, and the first to third selection circuits 37 to 39. Furthermore, the structures and the functions of the cathode wiring 41 and the gate wiring 42 according to the present embodiment are also the same as those of the cathode wiring 41 and the gate wiring 42 according to the first embodiment. In this regard, since the value of N according to the present embodiment is not three but four, each cathode wiring 41 is electrically connected with the four light-emitting elements 23, and each gate wiring 42 is electrically connected with the four transistors 24.

The value of N is desirably set to an appropriate value according to usage of the light-emitting device 1a. For example, decreasing the value of N provides an advantage that it is possible to reduce the impedance of the wiring for each light-emitting element 23, and an advantage that it is possible to reduce the numbers of capacitors and selection circuits. On the other hand, increasing the value of N provides an advantage that it is possible to reduce the numbers of the cathode wirings 41 and the gate wirings 42, and an advantage that it is possible to increase a common number of the cathode wirings 41 to be connected to the transistor 24, and enhance driving performance of the transistors 24.

### (Third Embodiment)

Fig. 20 is a plan view schematically illustrating the structure of the light-emitting device 1a according to the third embodiment.

The light-emitting device 1a according to the present embodiment has the structure illustrated in Fig. 4 similarly to the light-emitting device 1a according to the first embodiment. Furthermore, the light-emitting device 1a according to the present embodiment has the structure illustrated in A and B of Fig. 20.

A of Fig. 20 schematically illustrates the shape of the LD chip 11 in plan view. Each region R1 illustrated in A of Fig. 20 indicates a region occupied by the one light-emitting element 23. The area of each region R1 corresponds to the size of the one light-emitting element 23. A of Fig. 20 illustrates the 9×9 regions R1 in association with the 9×9 light-emitting elements 23.

B of Fig. 20 schematically illustrates the shape of the LDD substrate chip 12 in plan view. The LDD substrate 12 according to the present embodiment includes a region in which the drive circuits E (transistors 24) are disposed, and a region in which the peripheral circuit is disposed. Each region R2 illustrated in B of Fig. 20 indicates a region occupied by the one drive circuit E (three light-emitting elements 24). The area of each region R2 corresponds to the size of the one drive circuit E. B of Fig. 20 illustrates the 27 regions R2 in association with the 27 drive circuits E.

In the present embodiment, the size of the one drive circuit E is the same as the size of the three light-emitting elements 23. That is, the area of the one region R2 is the same as the area of the three regions R1 as illustrated in A and B of Fig. 20. More specifically, the shape of the one region R2 is congruent to the shape of the three regions R1.

Such a structure is suitable when, for example, the structure illustrated in A of Fig. 18 is adopted. In A of Fig. 18, the LD chip 11 is stacked on the LDD substrate 12. In this case, when the size of the one drive circuit E is the same as the size of the three light-emitting elements 23, it is possible to dispose each drive circuit E just below the three corresponding light-emitting elements 23. Consequently, it is possible to further reduce the impedance of the wiring for each light-emitting element 23. Note that, when each drive circuit E corresponds to the N light-emitting elements 23, it is desirable to make the size of the one drive circuit E the same as the size of the N light-emitting elements 23.

Note that the light-emitting device 1a according to the first to third embodiments is used as a light source of the ranging device 1, yet may be other aspects. For example, the light-emitting device 1a according to these embodiments may be used as light sources of optical devices such as printers, or may be used as lighting devices.

While embodiments of the present disclosure have been described above, these embodiments may be implemented with various modifications without departing from the spirit of the present disclosure. For example, a combination of two or more embodiments may be implemented.

Here, the present disclosure may also have the following configuration.
(1) A light emitting device includes:
   a plurality of light-emitting elements that are disposed in a two-dimensional array, and each include first and second terminals;
   a plurality of first terminal wirings that include first to Nth horizontal wirings (N represents an integer equal to or more than two) extending in a horizontal direction, and first to Nth vertical wirings extending in a vertical direction and electrically connected to the first to Nth horizontal wirings, respectively, and are electrically connected to the first terminals of the light-emitting elements;
   a plurality of second terminal wirings that are electrically connected to the second terminals of the light-emitting elements, and are each electrically connected to N light-emitting elements of the light-emitting elements;
   a plurality of selection circuits that are electrically connected to ones of the first and second terminal wirings, and select the light-emitting element that is caused to produce light; and
   a plurality of drive circuits that are electrically connected to other ones of the first and second terminal wirings, and drive the light-emitting elements.
(2) In the light-emitting device described in (1),
   one of the first and second terminals of the light-emitting element is an anode, other one of the first and second terminals of the light-emitting element is a cathode,
   one of the first and second terminal wirings is an anode wiring, and
   other one of the first and second terminal wirings is a cathode wiring.
(3) In the light-emitting device described in (1), the plurality of first terminal wirings include M sets (M represents an integer equal to or more than two) of the first to Nth horizontal wirings and the first to Nth vertical wirings.
(4) In the light-emitting device described in (1), the plurality of selection circuits include first to Nth selection circuits that are electrically connected to the first to Nth horizontal wirings or the first to Nth vertical wirings, respectively, and
   the plurality of drive circuits are each electrically connected to one of the second terminal wirings.
(5) In the light-emitting device described in (4), one of the first to Nth selection circuits and two or more of the plurality of drive circuits are turned on to cause two or more of the light-emitting elements to simultaneously emit light.
(6) In the light-emitting device described in (4), two or more of the first to Nth selection circuits and one of the plurality of drive circuits are turned on to cause two or more of the light-emitting elements to simultaneously emit light.
(7) In the light-emitting device described in (1), the plurality of selection circuits are each electrically connected to one of the second terminal wirings, and the plurality of drive circuits include first to third drive circuits that are electrically connected to the first to Nth horizontal wirings or the first to Nth vertical wirings, respectively.
(8) The light-emitting device described in (1) further includes a plurality of capacitors that are electrically connected to the ones of the first and second terminal wirings, and accumulate a charge to be supplied to the light-emitting elements.
(9) In the light-emitting device described in (8), the plurality of capacitors include first to Nth capacitors that are electrically connected to the first to Nth horizontal wirings or the first to Nth vertical wirings, respectively.
(10) In the light-emitting device described in (9), the plurality of capacitors include K sets (K represents an integer equal to or more than two) of the first to Nth capacitors that are disposed near two or more sides of four sides of an array of the light-emitting elements.
(11) In the light-emitting device described in (9), the plurality of capacitors include K sets (K represents an integer equal to or more than two) of the first to Nth capacitors that are disposed symmetrically with respect to a center of an array of the light-emitting elements.
(12) In the light-emitting device described in (8), the plurality of capacitors are each electrically connected to one of the second terminal wirings.
(13) In the light-emitting device described in (8), the plurality of capacitors are disposed on a first substrate provided with the light-emitting elements, a second substrate provided with at least ones of the selection circuits and the drive circuits, or a mounting substrate provided with the first and second substrates.
(14) In the light-emitting device described in (8), each of the plurality of selection circuits includes a first switch that accumulates a charge in the capacitors, and a second switch that discharges the charge from the capacitors.
(15) The light-emitting device described in (14) further includes a plurality of voltage detection circuits that detect a voltage indicating an amount of a charge accumulated in the plurality of capacitors, and control the first switch on a basis of the voltage.
(16) In the light-emitting device described in (1), a charge to be supplied to the light-emitting elements is accumulated in parasitic capacitances of the light-emitting elements or the drive circuits.
(17) In the light-emitting device described in (1), each of the plurality of drive circuits includes a first transistor that selects the light-emitting element that is caused to produce the light, and a second transistor that functions as a current source.
(18) In the light-emitting device described in (1), the first substrate provided with the light-emitting elements is stacked on the second substrate provided with at least ones of the selection circuits and the drive circuits.
(19) In the light-emitting device described in (1), a size of one of the plurality of drive circuits is same as a size of N light-emitting elements of the plurality of light-emitting elements in plan view.
(20) A ranging device includes:
   a light-emitting unit that produces light and emits the light to a subject;
   a light receiving unit that receives the light reflected from the subject; and
   a ranging unit that measures a distance to the subject on a basis of the light received by the light receiving unit, and
   the light-emitting unit includes:
      a plurality of light-emitting elements that are disposed in a two-dimensional array, and each include first and second terminals;
      a plurality of first terminal wirings that include first to Nth horizontal wirings (N represents an integer equal to or more than two) extending in a horizontal direction, and first to Nth vertical wirings extending in a vertical direction and electrically connected to the first to Nth horizontal wirings, respectively, and are electrically connected to the first terminals of the light-emitting elements;
      a plurality of second terminal wirings that are electrically connected to the second terminals of the light-emitting elements, and are each electrically connected to N light-emitting elements of the light-emitting elements;
      a plurality of selection circuits that are electrically connected to ones of the first and second terminal wirings, and select the light-emitting element that is caused to produce light; and
      a plurality of drive circuits that are electrically connected to other ones of the first and second terminal wirings, and drive the light-emitting elements.

### [Reference Signs List]

- 1: Ranging device
- 1a: Light-emitting device
- 2: Light-emitting unit
- 2a: Light-emitting element
- 3: Drive unit
- 4: Power supply circuit
- 5: Light-emitting side optical system
- 6: Light receiving side optical system
- 7: Light receiving unit
- 8: Signal processing unit
- 9: Control unit
- 9a: Ranging unit
- 10: Temperature detection unit
- 11: LD chip
- 12: LDD substrate
- 13: Mounting substrate
- 14: Heat dissipation substrate
- 15: Correction lens holding part
- 16: Correction lens
- 17: Wiring
- 21: Substrate
- 22: Laminated film
- 23: Light-emitting element
- 23': Parasitic capacitance
- 24: Transistor
- 24': Parasitic capacitance
- 25: Transistor
- 31: First anode wiring
- 31a: First horizontal wiring
- 31b: First vertical wiring
- 32: Second anode wiring
- 32a: Second horizontal wiring
- 32b: Second vertical wiring
- 33: Third anode wiring
- 33a: Third horizontal wiring
- 33b: Third vertical wiring
- 31': First cathode wiring
- 31a': First horizontal wiring
- 31b': First vertical wiring
- 32': Second cathode wiring
- 32a': Second horizontal wiring
- 32b': Second vertical wiring
- 33': Third cathode wiring
- 33a': Third horizontal wiring
- 33b': Third vertical wiring
- 34: First capacitor
- 35: Second capacitor
- 36: Third capacitor
- 37: First selection circuit
- 37a: Transistor
- 37b: Transistor
- 38: Second selection circuit
- 38a: Transistor
- 38b: Transistor
- 39: Third selection circuit
- 39a: Transistor
- 39b: Transistor
- 41: Cathode wiring
- 41': Anode wiring
- 42: Gate wiring
- 42': Gate wiring
- 43: Gate wiring
- 51: Insulation substrate
- 52: Insulating film
- 53: Wiring layer
- 54: Insulating film
- 55: Wiring layer
- 56: Wiring
- 57: Solder ball
- 58: Solder ball
- 59: Bump
- 61: First transistor
- 62: Second transistor
- 63: Third transistor
- 64: First gate wiring
- 65: Second gate wiring
- 66: Third gate wiring
- 67: Capacitor
- 68: Selection circuit
- 68a: Transistor
- 68b: Transistor
- 71: First voltage detection circuit
- 72: Second voltage detection circuit
- 73: Third voltage detection circuit
- 81: Fourth anode wiring
- 81a: Fourth horizontal wiring
- 81b: Fourth vertical wiring
- 82: Fourth capacitor
- 83: Fourth selection circuit
- 83a: Transistor
- 83b: Transistor

## Claims

1. A light-emitting device comprising:
a plurality of light-emitting elements that are disposed in a two-dimensional array, and each include first and second terminals;
a plurality of first terminal wirings that include first to Nth horizontal wirings (N represents an integer equal to or more than two) extending in a horizontal direction, and first to Nth vertical wirings extending in a vertical direction and
electrically connected to the first to Nth horizontal wirings, respectively, and are electrically connected to the first terminals of the light-emitting elements;
a plurality of second terminal wirings that are electrically connected to the second terminals of the light-emitting elements, and are each electrically connected to N light-emitting elements of the light-emitting elements;
a plurality of selection circuits that are electrically connected to ones of the first and second terminal wirings, and select the light-emitting element that is caused to produce light; and
a plurality of drive circuits that are electrically connected to other ones of the first and second terminal wirings, and drive the light-emitting elements.

2. The light-emitting device according to claim 1, wherein
one of the first and second terminals of the light-emitting element is an anode,
other one of the first and second terminals of the light-emitting element is a cathode,
one of the first and second terminal wirings is an anode wiring, and
other one of the first and second terminal wirings is a cathode wiring.

3. The light-emitting device according to claim 1, wherein the plurality of first terminal wirings include M sets (M represents an integer equal to or more than two) of the first to Nth horizontal wirings and the first to Nth vertical wirings.

4. The light-emitting device according to claim 1, wherein
the plurality of selection circuits include first to Nth selection circuits that are electrically connected to the first to Nth horizontal wirings or the first to Nth vertical wirings, respectively, and
the plurality of drive circuits are each electrically connected to one of the second terminal wirings.

5. The light-emitting device according to claim 4, wherein one of the first to Nth selection circuits and two or more of the plurality of drive circuits are turned on to cause two or more of the light-emitting elements to simultaneously emit light.

6. The light-emitting device according to claim 4, wherein two or more of the first to Nth selection circuits and one of the plurality of drive circuits are turned on to cause two or more of the light-emitting elements to simultaneously emit light.

7. The light-emitting device according to claim 1, wherein
the plurality of selection circuits are each electrically connected to one of the second terminal wirings, and
the plurality of drive circuits include first to third drive circuits that are electrically connected to the first to Nth horizontal wirings or the first to Nth vertical wirings, respectively.

8. The light-emitting device according to claim 1 further comprising a plurality of capacitors that are electrically connected to the ones of the first and second terminal wirings, and accumulate a charge to be supplied to the light-emitting elements.

9. The light-emitting device according to claim 8, wherein the plurality of capacitors include first to Nth capacitors that are electrically connected to the first to Nth horizontal wirings or the first to Nth vertical wirings, respectively.

10. The light-emitting device according to claim 9, wherein the plurality of capacitors include K sets (K represents an integer equal to or more than two) of the first to Nth capacitors that are disposed near two or more sides of four sides of an array of the light-emitting elements.

11. The light-emitting device according to claim 9, wherein the plurality of capacitors include K sets (K represents an integer equal to or more than two) of the first to Nth capacitors that are disposed symmetrically with respect to a center of an array of the light-emitting elements.

12. The light-emitting device according to claim 8, wherein the plurality of capacitors are each electrically connected to one of the second terminal wirings.

13. The light-emitting device according to claim 8, wherein the plurality of capacitors are disposed on a first substrate provided with the light-emitting elements, a second substrate provided with at least ones of the selection circuits and the drive circuits, or a mounting substrate provided with the first and second substrates.

14. The light-emitting device according to claim 8, wherein each of the plurality of selection circuits includes a first switch that accumulates a charge in the capacitors, and a second switch that discharges the charge from the capacitors.

15. The light-emitting device according to claim 14 further comprising a plurality of voltage detection circuits that detect a voltage indicating an amount of a charge accumulated in the plurality of capacitors, and control the first switch on a basis of the voltage.

16. The light-emitting device according to claim 1, wherein a charge to be supplied to the light-emitting elements is accumulated in parasitic capacitances of the light-emitting elements or the drive circuits.

17. The light-emitting device according to claim 1, wherein each of the plurality of drive circuits includes a first transistor that selects the light-emitting element that is caused to produce the light, and a second transistor that functions as a current source.

18. The light-emitting device according to claim 1, wherein the first substrate provided with the light-emitting elements is stacked on the second substrate provided with at least ones of the selection circuits and the drive circuits.

19. The light-emitting device according to claim 1, wherein a size of one of the plurality of drive circuits is same as a size of N light-emitting elements of the plurality of light-emitting elements in plan view.

20. A ranging device comprising:
a light-emitting unit that produces light and emits the light to a subject;
a light receiving unit that receives the light reflected from the subject; and
a ranging unit that measures a distance to the subject on a basis of the light received by the light receiving unit,
wherein the light-emitting unit includes:
a plurality of light-emitting elements that are disposed in a two-dimensional array, and each include first and second terminals;
a plurality of first terminal wirings that include first to Nth horizontal wirings (N represents an integer equal to or more than two) extending in a horizontal direction, and first to Nth vertical wirings extending in a vertical direction and electrically connected to the first to Nth horizontal wirings, respectively, and are electrically connected to the first terminals of the light-emitting elements;
a plurality of second terminal wirings that are electrically connected to the second terminals of the light-emitting elements, and are each electrically connected to N light-emitting elements of the light-emitting elements;
a plurality of selection circuits that are electrically connected to ones of the first and second terminal wirings, and select the light-emitting element that is caused to produce light; and
a plurality of drive circuits that are electrically connected to other ones of the first and second terminal wirings, and drive the light-emitting elements.
